# EUROPEAN PATENT APPLICATION

(11) **EP 4 835 951 A1**
(43) Date of publication of application: **04.11.2026**
(21) Application number: 24912956.0
(22) Date of filing: 25.12.2024
(51) Int. Cl.: H01L 21/02, C09J 5/00, C09J 7/38

(54) **METHOD FOR MANUFACTURING LAMINATE, METHOD FOR MANUFACTURING TWO-DIMENSIONAL MATERIAL LAMINATE, AND TWO-DIMENSIONAL MATERIAL**

(30) Priority: 28.12.2023 JP 2023223306
(71) Applicant: Nitto Denko Corporation, Ibaraki-shi, Osaka 567-8680 (JP); Kyushu University, National University Corporation, Nishi-ku Fukuoka-shi Fukuoka 819-0395 (JP); Institute For 2D Materials LLC., Fukuoka-shi, Fukuoka 812-0023 (JP)
(72) Inventor: HONDA, Satoshi, Ibaraki-shi, Osaka 567-8680 (JP); AGO, Hiroki, Fukuoka-shi, Fukuoka 819-0395 (JP); NAKATANI, Maki, Fukuoka-shi, Fukuoka 819-0395 (JP); KAWAHARA, Kenji, Fukuoka-shi, Fukuoka 812-0023 (JP)
(74) Representative: Müller-Boré & Partner Patentanwälte PartG mbB
(86) International application number: PCT/JP2024/046047
(87) International publication number: WO 2025/143070

(57) **Abstract**

This method for manufacturing a laminate includes: a step for forming air bubbles between a first substrate and a two-dimensional material in a state in which a support layer has been attached to a two-dimensional material on the first substrate; and a step for separating the laminate including the support layer and the two-dimensional material from the first substrate by forming the bubbles or by pulling at least one of the support layer and the first substrate after forming the bubbles. The support layer has re-peelability, and the tensile elastic modulus of the laminate at 23°C is 10-3000 MPa.

## Description

### TECHNICAL FIELD

The present invention relates to a method for manufacturing a laminate, a method for manufacturing a two-dimensional material laminate, and a two-dimensional material.

### BACKGROUND ART

Two-dimensional materials, such as two-dimensional carbon materials, are expected to find various applications, including wiring materials and transparent electrodes, because of their favorable electrical properties and optical properties. Among two-dimensional carbon materials, graphene, which is a conductive planar crystal of sp²-bonded carbon atoms, has high light transmittance and electrical conductivity, and is expected to be used for transparent conductive films, transparent electrodes, transistors, and the like.

Graphene has been produced by methods such as chemical vapor deposition (CVD) on a catalytic metal surface. However, when graphene is used in a device, a step of separating and transferring the graphene formed on the catalytic metal is required.

Patent Literature 1 describes, as a method for separating graphene formed on a metal substrate over a large area, a method in which bubbles are formed at an interface between the graphene and the metal substrate, thereby separating a laminate including the graphene and a support layer from a surface of the metal substrate.

### CITATION LIST

### Patent Literature

Patent Literature 1: WO2013/043120A1

### SUMMARY OF INVENTION

### Technical Problem

Patent Literature 1 discloses that, after polymethyl methacrylate (PMMA) as a support layer is coated on graphene, bubbles are generated between the metal substrate and the graphene by an electrochemical technique, thereby separating a laminate including the support layer and the graphene from the metal substrate. However, in such a method, when the graphene is subsequently transferred to a work substrate, a solvent cleaning step for removing the PMMA coating layer is required, resulting in a productivity issue. Contamination due to PMMA residue is also an issue.

As a result of extensive studies, the present inventors have also found a new issue in that, when the support layer has a high elastic modulus, bubbles contributing to separation escape from an edge of the laminate including the graphene and the support layer before the bubbles become sufficiently large, making large-area separation difficult.

In view of the foregoing, one object of the present disclosure is to provide a method for manufacturing a laminate including a two-dimensional material and a support layer, the method being capable of manufacturing, even when the two-dimensional material has a large area, a laminate from which the two-dimensional material can be efficiently transferred with a high transfer rate and low contamination. Solution to Problem

A method for manufacturing a laminate according to the present disclosure is a method for manufacturing a laminate, including:
a step of forming bubbles between a first substrate and a two-dimensional material in a state in which a support layer is attached to the two-dimensional material on the first substrate; and
a step of separating a laminate including the support layer and the two-dimensional material from the first substrate by forming the bubbles, or by pulling at least one of the support layer and the first substrate after forming the bubbles, wherein
the support layer has re-peelability, and
the laminate has a tensile elastic modulus at 23°C of 10 to 3000 MPa under the measurement conditions set forth below.

### Measurement conditions for the tensile elastic modulus of the laminate

The tensile elastic modulus of the laminate is an initial tensile elastic modulus calculated from a slope at a point at which a slope of stress with respect to strain is maximum between 10% strain and 100% strain when a sample of the laminate having a width of 10 mm and a length of 20 mm is gripped at upper and lower 5-mm portions in the length direction and pulled at a speed of 50 mm/min.

A method for manufacturing a two-dimensional material laminate according to the present disclosure is a method for manufacturing a two-dimensional material laminate, including:
a step of placing, on a second substrate, the laminate obtained by the above-described method for manufacturing a laminate such that a surface of the two-dimensional material of the laminate is in contact with the second substrate; and
a step of transferring the two-dimensional material onto the second substrate by peeling the support layer, thereby obtaining a two-dimensional material laminate including the second substrate and the two-dimensional material.

A two-dimensional material according to the present disclosure is a two-dimensional material laminated on a second substrate and having an area of 100 mm² or more.

### Advantageous Effects of Invention

According to the method for manufacturing a laminate of the present disclosure, even when a two-dimensional material has a large area, it is possible to manufacture a laminate from which the two-dimensional material can be efficiently transferred with a high transfer rate and low contamination. Further, when the two-dimensional material is transferred to another substrate using the laminate, a two-dimensional material having little surface contamination can be obtained.

### BRIEF DESCRIPTION OF DRAWINGS

[Fig. 1] Fig. 1 is a schematic cross-sectional view showing a laminate (first laminate) having a two-dimensional material on a first substrate.
[Fig. 2] Fig. 2 is a schematic cross-sectional view showing a state (second laminate) in which a support layer is attached to the two-dimensional material on the first substrate.
[Fig. 3] Fig. 3 is a schematic cross-sectional view showing a state in which bubbles are formed between the first substrate and the two-dimensional material.
[Fig. 4] Fig. 4 is a schematic cross-sectional view of a laminate (third laminate) including the support layer and the two-dimensional material.
[Fig. 5] Fig. 5 is a schematic cross-sectional view showing a state (fourth laminate) in which the laminate (third laminate) including the support layer and the two-dimensional material is placed on the second substrate such that the surface of the two-dimensional material of the laminate is in contact with the second substrate.
[Fig. 6] Fig. 6 is a schematic cross-sectional view showing a step of obtaining a two-dimensional material laminate including the second substrate and the two-dimensional material by peeling the support layer from the fourth laminate.

### DESCRIPTION OF EMBODIMENT

An embodiment of the present invention will be described below in detail. However, the present invention is not limited to such embodiments.

In the drawings below, members and portions having the same function may be denoted by the same reference signs, and repetitive descriptions thereof may be omitted or simplified. In addition, the embodiment shown in the drawings is schematically illustrated for clearly describing the present invention, and does not necessarily accurately represent the actual product size or scale.

Further, in the present specification, when a numerical range is expressed using "to," the expression includes the numerical values or physical property values recited before and after "to."

### [Method for Manufacturing a Laminate]

A method for manufacturing a laminate according to one embodiment is a method for manufacturing a laminate, including:
a step of forming bubbles between a first substrate and a two-dimensional material in a state in which a support layer is attached to the two-dimensional material on the first substrate; and
a step of separating a laminate including the support layer and the two-dimensional material from the first substrate by forming the bubbles, or by pulling at least one of the support layer and the first substrate after forming the bubbles, wherein
the support layer has re-peelability, and
the laminate has a tensile elastic modulus at 23°C of 10 to 3000 MPa under the measurement conditions set forth below.

### Measurement conditions for the tensile elastic modulus of the laminate

The tensile elastic modulus of the laminate is an initial tensile elastic modulus calculated from a slope at a point at which a slope of stress with respect to strain is maximum between 10% strain and 100% strain when a sample of the laminate having a width of 10 mm and a length of 20 mm is gripped at upper and lower 5-mm portions in the length direction and pulled at a speed of 50 mm/min.

### Preliminary Step

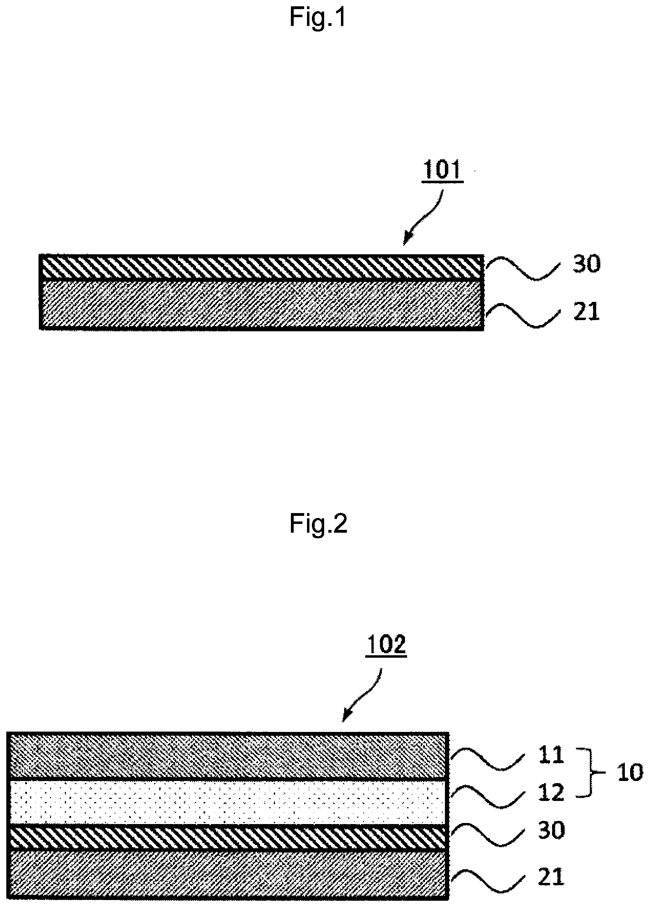

Fig. 1 is a schematic cross-sectional view showing a laminate 101 having a two-dimensional material 30 on a first substrate 21. The laminate 101 may also be referred to as a first laminate.

In the method for manufacturing a laminate according to the present embodiment, first, as a preliminary step, the two-dimensional material 30 is formed on the first substrate 21.

The first substrate 21 is not particularly limited, and may be any of a metal substrate, a ceramic substrate, a silicon substrate, a resin substrate, and the like.

Examples of the first substrate 21 include a metal substrate made of a single transition metal such as copper, nickel, cobalt, iron, chromium, gold, platinum, molybdenum, or tungsten; an alloy metal substrate of these metals; single-crystal substrates such as sapphire, magnesia, spinel, mica, SiC, SiN, and Si, and substrates obtained by oxidizing surfaces of such single-crystal substrates; a quartz substrate; a substrate for forming a two-dimensional material, in which a thin film of any of the above-listed transition metals is formed on a surface of each of these substrates; and a substrate on which a two-dimensional material is formed on each of the above substrates. The first substrate 21 is preferably a substrate for forming a two-dimensional material.

The method for forming the two-dimensional material on the metal substrate for film formation is not particularly limited, and a CVD method is preferably used. Examples of the film formation method include thermal CVD in which a source gas is introduced in the presence of a catalytic metal and treatment is carried out by thermal decomposition of the source gas, and surface-wave microwave plasma chemical vapor deposition (CVD) in which treatment is carried out by microwave plasma. Any method may be used as long as the two-dimensional material 30 can be formed on the first substrate 21.

The two-dimensional material 30 is a material having a two-dimensional layered structure composed of one elemental species or two or more elemental species, and having an extremely thin sheet structure. Graphene, which is a two-dimensional sheet composed only of carbon, is a representative example thereof. The two-dimensional material 30 may also be a ribbon-shaped film having a width on the nanometer scale.

Examples of the two-dimensional material 30 include a two-dimensional carbon material, a transition metal chalcogenide, molybdenum disulfide, tungsten disulfide, hexagonal boron nitride (h-BN), black phosphorus, and derivatives thereof. A two-dimensional carbon material, molybdenum disulfide, tungsten disulfide, or hexagonal boron nitride is preferred.

The two-dimensional carbon material is preferably graphene or a graphene derivative.

Graphene is a film formed of sp²-bonded carbon atoms having a thickness of one atom, and forms a hexagonal lattice structure made of carbon atoms and bonds thereof. In the present specification, multilayer graphene in which these films are stacked in 2 to 100 layers is also referred to as "graphene."

The two-dimensional material 30 may be a single-layer material or a multilayer material. When the two-dimensional material includes multiple layers, the layers may be composed of the same material or may be composed of different materials.

Examples of the graphene derivative include graphene oxide, sulfonated graphene oxide, graphene hydroxide, graphene carbonate, graphene nitride, and the like, with graphene oxide being preferred.

As a pretreatment, the laminate 101 may be subjected to immersion in water. For example, when the two-dimensional material is graphene and the catalyst for graphene film formation in the laminate 101 is Cu, the laminate 101 is immersed in water at 4 to 100°C for 4 to 72 hours. By such treatment, water is intercalated at the interface between the graphene and the Cu, and the Cu surface is oxidized. During immersion, the water may be left undisturbed or may be stirred. By stirring the water, the Cu surface is more readily oxidized. Methods are also available in which oxidation of Cu is promoted by adding a metal salt such as potassium chloride or sodium chloride to water, and in which Cu is oxidized by contact with water vapor. However, in any of these methods, water is intercalated at the interface between the graphene and the Cu, and the Cu surface is oxidized.

By this oxidation, the interaction between the graphene and the Cu is weakened, so that transfer of the graphene to the support layer 10 in a subsequent step can be reliably performed.

### Support Layer Attachment Step

Fig. 2 is a schematic cross-sectional view showing a state in which the support layer 10 is attached to the two-dimensional material 30 on the first substrate 21. A laminate obtained by attaching the support layer 10 to the two-dimensional material 30 on the first substrate 21 is defined as a laminate 102. The laminate 102 in which the first substrate 21, the two-dimensional material 30, and the support layer 10 are laminated in that order may be referred to as a second laminate.

In the method for manufacturing a laminate according to the present embodiment, the support layer 10 is attached to the two-dimensional material 30 on the first substrate 21.

By placing the support layer 10 on the two-dimensional material 30 of the laminate 101, which includes the first substrate 21 and the two-dimensional material 30, the support layer 10 is attached to the two-dimensional material 30. Accordingly, the laminate 102 is obtained. In attaching the support layer 10 to the two-dimensional material 30, the two-dimensional material 30 and the support layer 10 may be pressure-bonded, for example, using a roller or the like.

After the laminate 102 is obtained, autoclave treatment may optionally be performed. The conditions for the autoclave treatment are not particularly limited. For example, the temperature is preferably 20 to 300°C, and more preferably 30 to 70°C. The pressure is preferably 1.1 to 20 atm, and more preferably 2 to 10 atm. The treatment time is preferably 1 to 120 minutes, and more preferably 10 to 60 minutes.

In Fig. 2, an embodiment is shown in which, as the support layer 10, an adhesive tape having a base material 11 and an adhesive layer 12 is used. However, this merely shows one embodiment, and the support layer 10 need only have re-peelability.

### Pre-Curing Step

The method for manufacturing a laminate according to the present embodiment may include a pre-curing step after the support layer attachment step and before a bubble formation step described below. The pre-curing step is optional.

The pre-curing step is a step of curing the adhesive layer when an adhesive tape having an adhesive layer curable upon supply of specified energy or a specified substance is used as the support layer 10.

Hereinafter, an adhesive layer curable upon supply of specified energy or a specified substance may be referred to as a curable adhesive layer. In addition, an adhesive tape having a curable adhesive layer may be referred to as a curable adhesive tape.

When a curable adhesive tape is used as the support layer 10, in the support layer attachment step described above, the adhesive layer 12 of the support layer 10 (curable adhesive tape) readily conforms to the shape of the two-dimensional material. In addition, by performing a curing step before the bubble formation step and the separation step described below, the support layer 10 (curable adhesive tape) becomes sufficiently hard to suppress deformation of the two-dimensional material 30 when the laminate including the support layer 10 and the two-dimensional material 30 is separated from the first substrate 21 in the separation step. Accordingly, the two-dimensional material 30 can be separated from the first substrate 21 over a large area and in an undamaged or less damaged state. As a result, a two-dimensional material having a high transfer rate is readily obtained. In one aspect, when the two-dimensional material is graphene, graphene having a high transfer rate and high mobility is readily obtained.

The curable adhesive layer and the curable adhesive tape will be described in further detail in the description of the "support layer" provided below.

### Bubble Formation Step

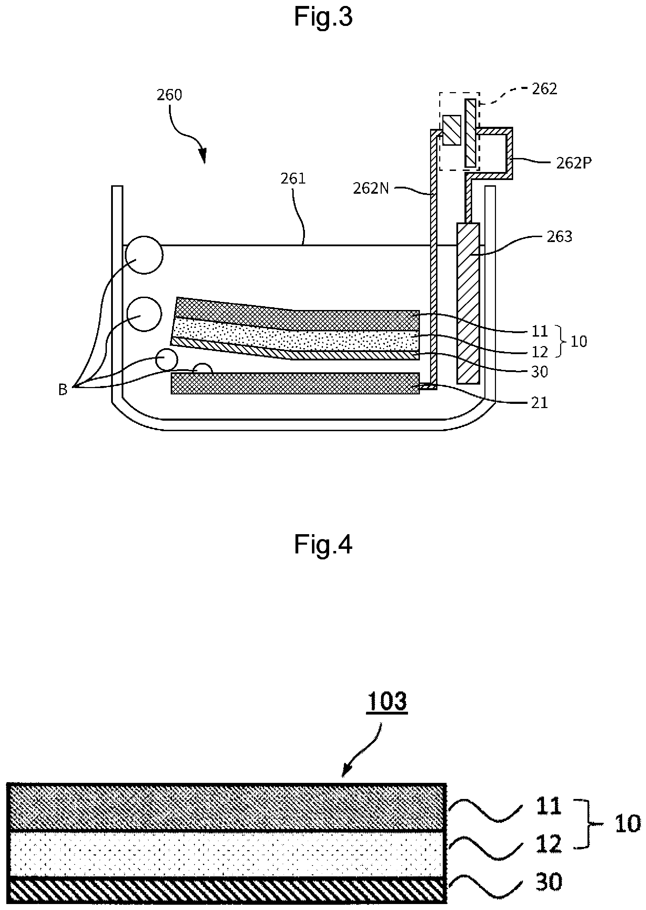

Fig. 3 is a schematic cross-sectional view showing a state in which bubbles B are formed between the first substrate 21 and the two-dimensional material 30. Fig. 3 shows a state in which, by formation of bubbles in the bubble formation step, separation of a laminate 103 including the support layer 10 and the two-dimensional material 30 from the first substrate 21 has occurred.

In the method for manufacturing a laminate according to the present embodiment, bubbles B are subsequently formed between the first substrate 21 and the two-dimensional material 30. In forming the bubbles B between the first substrate 21 and the two-dimensional material 30, a bubble formation unit 260 is used. The bubble formation unit 260 includes at least a solution 261, a voltage source 262 having a positive lead 262P and a negative lead 262N, such as a power supply or a battery, and an anode 263 located in the solution 261 and electrically connected to the positive lead 262P.

The laminate (second laminate) 102 is immersed in the solution 261 of the bubble formation unit 260. In a state in which the laminate (second laminate) 102 is immersed in the solution 261, the negative lead 262N is electrically connected to the first substrate 21 in the solution 261. Accordingly, the first substrate 21 functions as a cathode of the bubble formation unit 260.

The bubbles B are formed between the first substrate 21 and the two-dimensional material 30, for example, by an electrochemical reaction in the bubble formation unit 260. As one example, the electrochemical reaction is release of hydrogen by electrolysis of water in the solution 261, and the bubbles B are formed by the electrochemical reaction.

Specifically, when a potential is applied in the solution 261, a reduction reaction occurs at the negatively charged first substrate 21 (cathode), hydrogen gas is generated from the first substrate 21, and hydrogen bubbles B are formed on a conductive surface of the first substrate 21. As a result, the bubbles B are formed between the first substrate 21 and the two-dimensional material 30. In the bubble formation unit 260, the arrangement of the anode 263 is adjusted such that the bubbles B are formed in a concentrated manner between the first substrate 21 and the two-dimensional material 30.

The solution 261 includes water and at least one electrolyte, and preferably includes 0.01 mol to 10 mol of the electrolyte per liter of water.

The electrolyte is not particularly limited, and may be a single electrolyte or a combination of two or more electrolytes.

Examples of the electrolyte include sodium hydroxide, potassium hydroxide, sulfuric acid, sodium chloride, and any suitable combination thereof.

### Separation Step

The method for manufacturing a laminate according to the present embodiment includes a step of separating the laminate 103 including the support layer 10 and the two-dimensional material 30 from the first substrate 21. Fig. 4 shows a schematic cross-sectional view of the laminate 103 including the support layer 10 and the two-dimensional material 30. The laminate 103 may be referred to as a third laminate.

Separation of the laminate 103 including the support layer 10 and the two-dimensional material 30 from the first substrate 21 may occur through formation of bubbles in the bubble formation step described above, as shown in Fig. 3. In this case, the bubble formation step and the separation step may also be regarded as being performed simultaneously.

Alternatively, separation of the laminate 103 including the support layer 10 and the two-dimensional material 30 from the first substrate 21 may be performed after the bubble formation step described above by pulling at least one of the support layer 10 and the first substrate 21.

The laminate 103 separated from the first substrate 21 may optionally be washed with a suitable cleaning liquid such as pure water, including deionized water and distilled water, ultrapure water, or an alcohol such as ethanol or isopropyl alcohol.

In the manufacturing method according to the present embodiment, the tensile elastic modulus of the laminate 103 including the support layer 10 and the two-dimensional material 30 is 10 to 3000 MPa. In view of handleability, the tensile elastic modulus of the laminate 103 is preferably 10 MPa or more, more preferably 40 MPa or more, and still more preferably 70 MPa or more. Further, the tensile elastic modulus of the laminate 103 is preferably 3000 MPa or less, more preferably 2000 MPa or less, still more preferably 1000 MPa or less, and yet more preferably 100 MPa or less. In a case in which the tensile elastic modulus of the laminate 103 is 3000 MPa or less, it is possible to suppress or prevent bubbles contributing to separation from escaping from an edge of the laminate 103 before the bubbles become sufficiently large when the bubbles are formed between the first substrate 21 and the two-dimensional material 30. Further, it is believed that, when the tensile elastic modulus of the laminate 103 is within the above range, the laminate 103 is appropriately separated from the first substrate 21 in the separation step, and favorable low contamination is achieved.

The tensile elastic modulus of the laminate 103 is a tensile elastic modulus measured at 23°C, and may be calculated for the laminate 103 after separation from the first substrate 21. Further, the tensile elastic modulus of the laminate 103 after separation from the first substrate is regarded as being substantially the same as the tensile elastic modulus of the laminate 103 during bubble formation.

Further, since the thickness of the two-dimensional material 30 is usually sufficiently small relative to the thickness of the support layer 10, the two-dimensional material 30 can be regarded as not substantially affecting the elastic modulus of the laminate 103. Accordingly, the tensile elastic modulus of the laminate 103 is usually regarded as being substantially the same as the tensile elastic modulus of the support layer 10.

Specifically, the tensile elastic modulus of the laminate can be calculated as follows.

A sample of the laminate of the support and the two-dimensional material (third laminate), having a width of 10 mm and a length of 20 mm, is prepared. Upper and lower 5- mm portions in the length direction are gripped so that the distance between the grips is 10 mm, and the sample is pulled at a speed of 50 mm/min. Using a tensile tester, the initial tensile elastic modulus is calculated from the slope at a point at which the slope of stress with respect to strain is maximum between 10% strain and 100% strain. The calculated value is defined as the tensile elastic modulus of the laminate (third laminate). In the case of anisotropy in which the tensile elastic modulus varies depending on the tensile direction, an average of tensile elastic moduli obtained by pulling in at least two in-plane directions orthogonal to each other is used. For example, an average value of values respectively measured using two in-plane orthogonal directions (the MD direction and the TD direction) as a long-side direction (length direction) is used.

Further, when the laminate 103 is separated from the first substrate 21 by pulling at least one of the support layer 10 and the first substrate 21 after the bubble formation step, the peel angle is not particularly limited and is usually 180 degrees or less. However, when the peel angle is relatively small, defects such as tearing and cracking in the two-dimensional material 30 can be prevented from occurring due to a change in shape of the laminate 103. For this reason, a smaller peel angle is preferred, and the peel angle is preferably 90 degrees or less, and more preferably 60 degrees or less. Further, the peel angle is preferably 0 degrees or more in view of avoiding an increase in the size of the peeling apparatus itself.

The peel angle refers to an angle formed between the first substrate 21 and a peeled portion of the laminate 103 when the laminate 103 is separated from the first substrate 21.

The peel rate when the laminate 103 is separated from the first substrate 21 is not particularly limited. However, when the peel rate is relatively high, the time during which a change in shape of the laminate 103 occurs is shortened, so that defects such as tearing and cracking in the two-dimensional material 30 can be prevented from occurring. For this reason, the peel rate is usually 1 mm/min or more, but a higher peel rate is preferred, with 10 mm/min or more being preferred and 100 mm/min or more being more preferred. Further, in view of stable operation of the apparatus, the peel rate is preferably 100000 mm/min or less, and more preferably 90000 mm/min or less.

The peel rate refers to the length by which the laminate 103 is peeled from the laminate 102 per unit time when the laminate 103 is separated from the laminate 102.

According to the method for manufacturing a laminate of the present embodiment, the bubbles that weaken the interaction between the first substrate 21 and the two-dimensional material 30 with a gentle force can be efficiently formed, and therefore the two-dimensional material 30 can be separated without tearing or damage even when the two-dimensional material 30 has a large area. As a result, even when the two-dimensional material 30 has a large area, the laminate 103 can be manufactured such that the two-dimensional material 30 can be efficiently transferred at a high transfer rate. A large area is, for example, an area of 100 mm² or more. However, it will be readily understood that the method for manufacturing a laminate according to the present embodiment is, of course, also applicable when the area of the two-dimensional material is relatively small, and such a case is also encompassed.

### [Method for Manufacturing a Two-Dimensional Material Laminate]

A method for manufacturing a two-dimensional material laminate according to one embodiment is a method for manufacturing a two-dimensional material laminate, including:
a step of placing, on a second substrate, the laminate obtained by the above-described method for manufacturing a laminate such that a surface of the two-dimensional material of the laminate is in contact with the second substrate; and
a step of transferring the two-dimensional material onto the second substrate by peeling the support layer, thereby obtaining a two-dimensional material laminate including the second substrate and the two-dimensional material.

### Placement Step

In the method for manufacturing a two-dimensional material laminate according to the present embodiment, first, the laminate obtained by the above-described method for manufacturing a laminate is placed on the second substrate such that the surface of the two-dimensional material of the laminate is in contact with the second substrate.

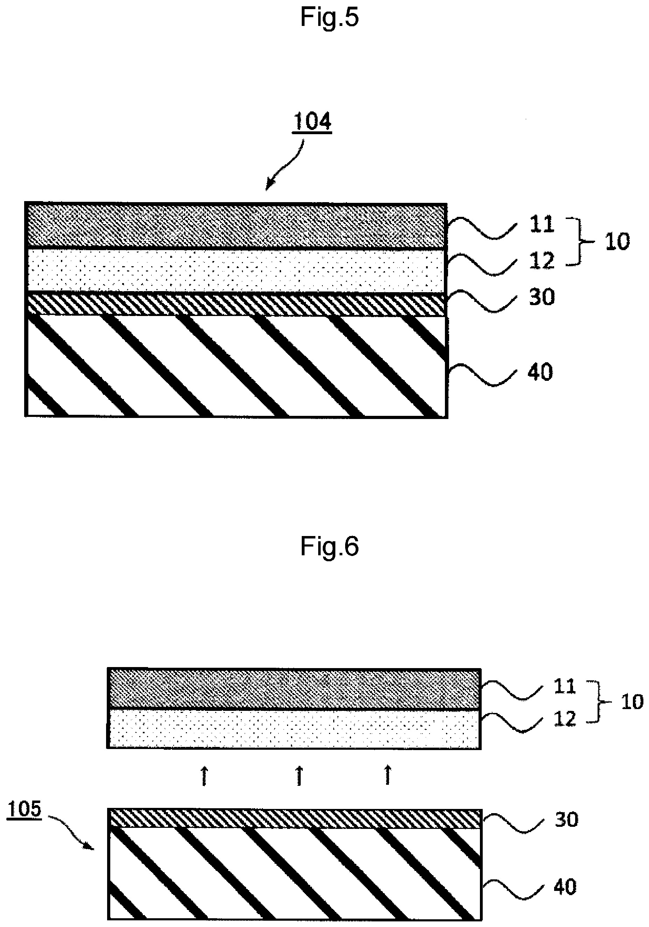

Fig. 5 is a schematic cross-sectional view showing a step (placement step) of placing the laminate 103 on the second substrate 40 such that the surface of the two-dimensional material 30 of the laminate 103 is in contact with the second substrate 40. Through the placement step, a laminate 104 is obtained in which the second substrate 40 and the laminate 103 are laminated.

When the laminate 103 is placed on the second substrate 40, the laminate 103 may optionally be placed on the second substrate in a state wetted with a suitable liquid such as water or an alcohol (liquid-assisted attachment), and then allowed to stand or dried. This increases the adhesion of the laminate 103 to the second substrate 40.

In placing the laminate 103 on the second substrate 40, the laminate 103 and the second substrate 40 may also be pressure-bonded, for example, using a roller or the like.

The laminate 103 may also be cut to an appropriate size as needed and arranged at any location on the second substrate 40. This allows the two-dimensional material to be placed at any desired location on the second substrate.

### Post-Curing Step

The method for manufacturing a two-dimensional material laminate according to the present embodiment may include a post-curing step after the placement step and before a transfer step described below. The post-curing step is optional.

The post-curing step is a step of curing the adhesive layer when an adhesive tape having an adhesive layer curable upon supply of specified energy or a specified substance is used as the support layer 10. However, the post-curing step is performed after the bubble formation step in the above-described method for manufacturing a laminate, and is distinguished from the pre-curing step performed before the bubble formation step.

Specifically, when a curable adhesive tape is used as the support layer 10, in the support layer attachment step described above, the adhesive layer 12 of the support layer 10 (curable adhesive tape) readily conforms to the shape of the two-dimensional material 30. In addition, by performing the post-curing step before the transfer step described below, the adhesive force of the adhesive layer 12 of the support layer 10 (curable adhesive tape) is reduced, so that the support layer 10 (curable adhesive tape) can be more readily peeled from the two-dimensional material 30 in the transfer step. As a result, a high transfer rate is readily obtained. In one aspect, when the two-dimensional material is graphene, graphene having a high transfer rate and high mobility is readily obtained.

In the present embodiment, either the pre-curing step or the post-curing step may be performed. However, in view of more readily obtaining a higher transfer rate and mobility, it is preferable to perform the pre-curing treatment.

### Transfer Step

Next, in the method for manufacturing a two-dimensional material laminate according to the present embodiment, the support layer is peeled to transfer the two-dimensional material onto the second substrate, thereby obtaining a two-dimensional material laminate including the second substrate and the two-dimensional material.

Fig. 6 is a schematic cross-sectional view showing a step of transferring the two-dimensional material 30 onto the second substrate 40 by peeling the support layer 10. By peeling the support layer 10 from the laminate 104, the two-dimensional material 30 is transferred onto the second substrate 40, and a laminate 105 including the second substrate 40 and the two-dimensional material 30 is obtained. The laminate 105 including the second substrate 40 and the two-dimensional material 30 may be referred to as a two-dimensional material laminate.

The peel angle when the support layer 10 is peeled from the laminate 104 is not particularly limited and is usually 180 degrees or less. However, when the peel angle is relatively large, stress is concentrated at the peel front of the support layer 10, so that the peel force at the interface between the support layer 10 and the two-dimensional material 30 is reduced, and defects such as tearing and cracking in the two-dimensional material 30 can be prevented from occurring. For this reason, a larger peel angle is preferred, and the peel angle is preferably 90 degrees or more, and more preferably 120 degrees or more. Further, the peel angle is preferably 180 degrees or less in view of the peeling mechanism.

The peel angle refers to an angle formed between the two-dimensional material 30 and a peeled portion of the support layer 10 when the support layer 10 is peeled from the laminate 104.

The peel rate when the support layer 10 is peeled from the laminate 104 is not particularly limited. However, when the peel rate is relatively low, the elastic properties of the support layer 10 become lower, so that the peeling force at the interface between the support layer 10 and the two-dimensional material 30 is reduced, and defects such as tearing and cracking in the two-dimensional material 30 are prevented from occurring. For this reason, the peel rate is usually 1000 mm/min or less, but a lower peel rate is preferred, with 600 mm/min or less being preferred and 300 mm/min or less being more preferred. Further, in view of stable operation of the apparatus, the peel rate is preferably 3 mm/min or more, and more preferably 10 mm/min or more.

The peel rate refers to a length by which the support layer 10 is peeled from the laminate 104 per unit time when the support layer 10 is peeled from the laminate 104.

The second substrate 40 is a substrate onto which a two-dimensional material is to be transferred. The second substrate 40 is preferably a substrate in which an adhesive force between a transfer surface thereof and the two-dimensional material 30 is stronger than an adhesive force between the two-dimensional material 30 and the adhesive layer 12 after specified energy or a specified substance has been applied. Such a second substrate 40 may itself have a strong interaction with the two-dimensional material, or may be one to which such an interaction has been imparted by surface treatment. Examples of the surface treatment include application of a curable resin, melting of the surface, formation of a fine structure, and surface chemical modification, but the method is not limited thereto.

The second substrate 40 is not particularly limited, and may be any of a metal substrate, a ceramic substrate, a silicon substrate, a resin substrate, and the like. Examples of the second substrate 40 that are preferred include an SiO₂/Si substrate, a quartz substrate, a glass substrate, a PET substrate, a sapphire substrate, an ITO substrate, and a substrate on which a two-dimensional material is laminated, with an SiO₂/Si substrate being more preferred.

The second substrate 40 may also be a substrate in which a film made of copper, nickel, iron, or a mixed oxide containing at least one thereof is partially formed on a surface of a suitable underlying substrate such as a metal substrate, a ceramic substrate, a silicon substrate, or a resin substrate. The area ratio occupied by the film relative to the surface area of the underlying substrate is preferably 80% or less, more preferably 70% or less. Further, the area ratio occupied by the film relative to the surface area of the underlying substrate is preferably 5% or more, and more preferably 15% or more.

The thickness of the second substrate 40 is not particularly limited and may be appropriately selected, but is preferably 1 µm or more, more preferably 10 µm or more, and still more preferably 100 µm or more. In view of handling, the thickness is preferably 100 mm or less, more preferably 20 mm or less, and still more preferably 5 mm or less.

The two-dimensional material laminate obtained by the method for manufacturing a two-dimensional material laminate according to the present embodiment can be employed in transparent conductive films for touchscreen applications and the like, semiconductor devices or electronic devices such as transistors and integrated circuits, and transparent electrodes and electrochemical electrodes requiring a large area.

### [Two-Dimensional Material]

The two-dimensional material of the embodiment is laminated on the second substrate and has an area of 100 mm² or more.

The two-dimensional material of the present embodiment can be obtained, for example, as the two-dimensional material in a two-dimensional material laminate manufactured by the above-described method for manufacturing a two-dimensional material laminate.

As the substrate on the surface of which the two-dimensional material is laminated, various substrates exemplified above as the second substrate can be used.

When the two-dimensional material is graphene, a substrate not having copper, nickel, or iron at its outermost surface is preferably used.

The two-dimensional material of the present embodiment preferably has an area of 100 mm² or more. The area of the two-dimensional material is more preferably 200 mm² or more, and still more preferably 7000 mm² or more. The upper limit of the area of the two-dimensional material is not particularly limited, but 200000 mm² or less is practical.

The transfer rate of the two-dimensional material is preferably 50% or more, more preferably 70% or more, still more preferably 90% or more, and particularly preferably 95% or more.

The transfer rate of the two-dimensional material can be calculated in the manner described in the Examples. In the Examples, with respect to a two-dimensional material (graphene) transferred onto a substrate having a size of 10 mm in length by 20 mm in width, the area ratio of graphene is determined as a percentage at a total of 9 points, namely, 1 central point and 8 points near the edges (4 vertices and 4 intermediate points therebetween), and the average value of the area ratios of graphene at those 9 points (9-point average transfer rate) is taken as the transfer rate (%). However, when the size or shape of the substrate is different, the 9 measurement points may be determined with reference to the case described in the Examples.

The contamination amount of the two-dimensional material is preferably -30% or more and 10% or less, more preferably -25% or more and 8% or less, and still more preferably -20% or more and 5% or less. Since residues present before transfer may be removed in the transfer step, the contamination amount may be negative. When the contamination amount of the two-dimensional material is less than -30%, the quality of the two-dimensional material before transfer deteriorates because the amount of residues before transfer is excessively large. When the contamination amount of the two-dimensional material exceeds 10%, the performance of the two-dimensional material after transfer deteriorates because the amount of residues after transfer is excessively large.

The contamination amount is determined as an increase in the elemental amount of carbon, calculated by ESCA analysis of the two-dimensional material laminated on a silicon substrate with an oxide film (manufactured by SUMCO Corporation, silicon (crystal plane (100)), surface thermal oxidation-oxide film thickness: 300 nm), relative to the elemental amount of carbon obtained by the same measurement on the surface of the two-dimensional material on the first substrate before attachment of the support layer.

Each carbon amount is determined, with the relevant substrate surface as the measurement target, as the elemental ratio of carbon (atomic %) out of the total amount of carbon, nitrogen, oxygen, silicon, and copper, by performing narrow-scan analysis for those five elements by X-ray photoelectron spectroscopy (ESCA). As the analyzer, "Quantum 2000" manufactured by ULVAC PHI, or an equivalent thereof, may be used. Specifically, the contamination amount can be determined by the method described in the Examples below.

When the two-dimensional material is graphene, the mobility of the graphene is preferably 2000 cm²/V/s or more, more preferably 3000 cm²/V/s or more, and still more preferably 4000 cm²/V/s or more.

The mobility of the two-dimensional material can be calculated in the manner described in the Examples.

### Support Layer

The support layer used in the method for manufacturing a laminate according to the present embodiment is not particularly limited as long as it has re-peelability, and examples thereof include an adhesive tape and an adsorption sheet. Among these, an adhesive tape is preferred as the support layer because the adhesive layer included in the adhesive tape is a viscoelastic body and therefore can wet and spread over the two-dimensional material, thereby facilitating a large-area pickup.

In the method for manufacturing a laminate according to the present embodiment, favorable low-contamination properties are believed to be obtained because the support layer has re-peelability.

In the present specification, re-peelability refers to a property whereby an article adhered to an adherend can be easily peeled from the adherend when the article is to be removed.

The adhesive force A, measured at 23°C, of the support layer with respect to a silicon wafer (180° peel force against a silicon wafer) is preferably 0.001 N/20 mm to 2.0 N/20 mm when measured by 180° peeling at a tensile speed of 300 mm/min. In view of handleability and the like, the adhesive force A is preferably 0.001 N/20 mm or more, more preferably 0.01 N/20 mm or more, still more preferably 0.03 N/20 mm or more, and yet more preferably 0.05 N/20 mm or more. Further, in view of favorable re-peelability, the adhesive force A is preferably 2.0 N/20 mm or less, more preferably 1.0 N/20 mm or less, still more preferably 0.5 N/20 mm or less, and yet more preferably 0.1 N/20 mm or less.

When the support layer is a curable adhesive tape described below, the adhesive force A may vary depending on whether the adhesive layer is cured and on the timing of curing. However, it is preferable that at least the adhesive force A after curing of the adhesive layer satisfy the above range.

Further, the adhesive force B, measured at 23°C, when the support layer is peeled from the two-dimensional material (180° peel force upon release from the two-dimensional material) is preferably 0.001 N/20 mm to 2.0 N/20 mm when measured by 180° peeling at a tensile speed of 300 mm/min. In view of handleability and the like, the adhesive force B is preferably 0.001 N/20 mm or more, more preferably 0.01 N/20 mm or more, still more preferably 0.05 N/20 mm or more, and yet more preferably 0.1 N/20 mm or more. Further, in view of favorable re-peelability, the adhesive force B is preferably 2.0 N/20 mm or less, more preferably 1.5 N/20 mm or less, still more preferably 0.5 N/20 mm or less, and yet more preferably 0.2 N/20 mm or less.

When the support layer is a curable adhesive tape described below, the adhesive force B may vary depending on whether the adhesive layer is cured and on the timing of curing. However, it is preferable that at least the adhesive force B when the support layer is peeled from the two-dimensional material satisfy the above range.

Examples of the adsorption tape used as the support layer include a foamed sheet and a gel sheet made of an acrylic resin, rubber, or the like.

The adhesive tape used as the support layer is not particularly limited as long as it includes an adhesive layer, and examples thereof include a baseless adhesive tape consisting only of an adhesive layer, and an adhesive tape with a base material including an adhesive layer and a base material. Among these, in view of handleability, an adhesive tape having an adhesive layer on one side of a base material (single-sided adhesive tape) is preferred. The concept of the adhesive tape herein may include what is referred to as an adhesive sheet, an adhesive film, an adhesive label, and the like.

The adhesive tape may be an adhesive tape having a non-curable adhesive layer, but is preferably a curable adhesive tape having an adhesive layer (curable adhesive layer) that is cured upon supply of specified energy or a specified substance.

Examples of the specified energy supplied for curing the adhesive layer include active energy rays and heat, with active energy rays being preferred. Examples of the active energy rays include ionizing radiation such as α-rays, β-rays, γ-rays, X-rays, neutron rays, and electron beams, and ultraviolet light and visible light. In view of versatility in consideration of equipment scale and reduction of damage to materials, radiation such as electron beams, ultraviolet light, α-rays, β-rays, γ-rays, and X-rays is preferred, and ultraviolet light is particularly preferred. That is, the adhesive layer is preferably an active-energy-ray-curable adhesive layer having a property of being cured by irradiation with active energy rays, more preferably a radiation-curable adhesive layer having a property of being cured by irradiation with radiation, and still more preferably an ultraviolet-curable adhesive layer having a property of being cured by irradiation with ultraviolet light.

The method for generating ultraviolet light is not particularly limited, and a known and commonly used generation method may be adopted. Examples thereof include a discharge lamp method (arc lamp), a flash method, a laser method, and a UV-LED method. In the present invention, in view of favorable industrial productivity, it is preferable to use a discharge lamp method (arc lamp) or a UV-LED method, and among these, in view of favorable irradiation efficiency, it is preferable to use an irradiation method employing a high-pressure mercury lamp, a metal halide lamp, or a UV-LED.

As the wavelength of the ultraviolet light, a wavelength in the ultraviolet region may be used without particular limitation, but it is preferable to use a wavelength of about 250 to 440 nm as a wavelength generally used for photopolymerization and used in the above ultraviolet generation method.

Examples of the substance supplied for curing the adhesive layer include a curing agent, moisture, and a reactive compound.

Examples of the polymer contained in the adhesive layer include known or commonly used polymers, such as a (meth)acrylic polymer, a urethane acrylate polymer, a urethane polymer, a rubber polymer, an epoxy polymer, an epoxy acrylate polymer, an oxetane polymer, a silicone polymer, a silicone acryl polymer, a polyester polymer, a polyether polymer (such as polyvinyl ether), a polyamide polymer, a fluoropolymer, a vinyl acetate/vinyl chloride copolymer, and a modified polyolefin. These polymers may be used alone or in a combination of two or more. Among these, a (meth)acrylic polymer is preferred. By using a (meth)acrylic polymer, the storage elastic modulus and tensile elastic modulus of the adhesive layer can be readily adjusted, and an adhesive composition having a favorable balance between adhesive force and peelability can be obtained. Further, contamination of an adherend due to components derived from the adhesive can be reduced. In the present specification, "(meth)acrylic" means "acrylic" and/or "methacrylic" (either one or both of "acrylic" and "methacrylic"), and the same applies to other similar expressions.

When the adhesive layer is an active-energy-ray-curable adhesive layer, examples of the adhesive layer include an adhesive layer containing, as a base polymer, a polymer having a radiation-polymerizable functional group, and an adhesive layer containing a base polymer and a radiation-polymerizable monomer component or oligomer component having a functional group such as a radiation-polymerizable carbon-carbon double bond. A combination thereof may also be used.

The following description mainly relates to an adhesive containing, as a base polymer, a polymer having a radiation-polymerizable functional group.

Examples of the radiation-polymerizable functional group include a radiation-radical-polymerizable group (radical-reactive group), such as a group containing a carbon-carbon unsaturated bond such as an ethylenically unsaturated group, and a radiation-cationically-polymerizable group. Examples of the group containing a carbon-carbon unsaturated bond include a vinyl group, a propenyl group, an isopropenyl group, an acryloyl group, and a methacryloyl group. Examples of the radiation-cationically polymerizable group include an epoxy group, an oxetanyl group, and an oxolanyl group. Among these, a group containing a carbon-carbon unsaturated bond is preferred, and an acryloyl group or a methacryloyl group is more preferred. The radiation-polymerizable functional group may be used alone or in a combination of two or more. The radiation-polymerizable functional group may be located in a polymer side chain, in a polymer main chain, or at a polymer main-chain terminus.

The following description relates to an active-energy-ray-curable adhesive composition containing, as a base polymer, a polymer having a radical-reactive carbon-carbon double bond, which is one preferred embodiment of the adhesive composition forming the adhesive layer in the adhesive tape.

In this embodiment, the adhesive composition is an active-energy-ray-curable adhesive composition containing, as a base polymer, a polymer having a radical-reactive carbon-carbon double bond (hereinafter, also referred to as a carbon-carbon unsaturated double bond) in a side chain and/or at an end.

The base polymer is preferably a polymer having a carbon-carbon unsaturated double bond at least in a side chain.

Examples of the base polymer include a (meth)acrylic polymer, a vinyl alkyl ether polymer, a silicone polymer, a polyester polymer, a polyamide polymer, a urethane polymer, and a styrene-diene block copolymer, and a (meth)acrylic polymer is preferably used.

The weight-average molecular weight of the base polymer is preferably 300,000 or more, more preferably 400,000 or more, and still more preferably 600,000 to 1,000,000. Within such a range, bleeding of low-molecular-weight components can be prevented, and a low-contamination adhesive composition can be obtained. The molecular weight distribution (weight average molecular weight/number average molecular weight) of the base polymer is preferably 1 to 20, and more preferably 3 to 10. By using a base polymer having a narrow molecular weight distribution, bleeding of low-molecular-weight components can be prevented, and a low-contamination adhesive composition can be obtained. The weight average molecular weight and the number average molecular weight can be determined by gel permeation chromatography measurement (solvent: tetrahydrofuran, in terms of polystyrene).

One embodiment of the adhesive composition used in the adhesive tape of the present embodiment includes a base polymer and a photopolymerization initiator. This base polymer is, for example, a polymer obtained by reacting a monomer composition containing a polymer and a monomer having a carbon-carbon unsaturated double bond. In this example, suitable components are appropriately selected such that the carbon-carbon unsaturated double bond is introduced into the polymer. In the present specification, the monomer composition may be a composition containing only monomers, or may be a composition containing monomers and any other component such as an oligomer and a polymer.

The base polymer is obtained, for example, by reacting a monomer composition (hereinafter also referred to as "base-polymer monomer composition 1") containing a polymer having a hydroxyl group and a monomer having a functional group including a carbon-carbon unsaturated double bond and an isocyanate group. By reacting the base-polymer monomer composition 1, the monomer having a functional group containing a carbon-carbon unsaturated double bond and an isocyanate group can undergo an addition reaction with the polymer having a hydroxyl group. As a result, a polymer is obtained that has a structural unit derived from the monomer having a functional group containing a carbon-carbon unsaturated double bond and an isocyanate group.

As the polymer having a hydroxyl group, a polymer obtained by introducing a hydroxyl group into any suitable polymer may be used. Examples thereof include polymers obtained by introducing a hydroxyl group into polymers such as a (meth)acrylic polymer, a vinyl alkyl ether polymer, a silicone polymer, a polyester polymer, a polyamide polymer, a urethane polymer, and a styrene-diene block copolymer. Preferably, a polymer obtained by introducing a hydroxyl group into a (meth)acrylic polymer is used.

The (meth)acrylic polymer having a hydroxyl group can be obtained, for example, by polymerizing a monomer composition including an ester of acrylic acid or methacrylic acid having any suitable linear or branched alkyl group, and a monomer having a hydroxyl group. The ester of acrylic acid or methacrylic acid having a linear or branched alkyl group may be used alone, or two or more thereof may be used in combination.

The linear or branched alkyl group is preferably an alkyl group having 30 or fewer carbon atoms, more preferably an alkyl group having 1 to 20 carbon atoms, and still more preferably an alkyl group having 4 to 18 carbon atoms. Specific examples of the alkyl group include a methyl group, an ethyl group, a propyl group, an isopropyl group, an n-butyl group, a t-butyl group, an isobutyl group, an amyl group, an isoamyl group, a hexyl group, a heptyl group, a cyclohexyl group, a 2-ethylhexyl group, an octyl group, an isooctyl group, a nonyl group, an isononyl group, a decyl group, an isodecyl group, an undecyl group, a lauryl group, a tridecyl group, a tetradecyl group, a stearyl group, an octadecyl group, and a dodecyl group.

As the hydroxyl-group-containing monomer, any suitable monomer may be used. Examples thereof include 2-hydroxymethyl acrylate, 2-hydroxyethyl acrylate, 2-hydroxypropyl acrylate, 3-hydroxypropyl acrylate, 4-hydroxybutyl acrylate, 2-hydroxymethyl methacrylate, 2-hydroxyethyl methacrylate, and N-(2-hydroxyethyl)acrylamide. Preferably, 2-hydroxymethyl acrylate, 2-hydroxyethyl acrylate, 4-hydroxybutyl acrylate, 2-hydroxymethyl methacrylate, and 2-hydroxyethyl methacrylate are used. These monomers may be used alone, or two or more thereof may be used in combination.

The hydroxyl-group-containing monomer is preferably 5 mol% to 40 mol%, more preferably 15 mol% to 30 mol%, and still more preferably 20 mol% to 25 mol%, relative to 100 mol% of all monomer components in the monomer composition used for polymerization of the polymer having a hydroxyl group. By polymerizing a monomer composition including the hydroxyl-group-containing monomer, a polymer having a hydroxyl group is obtained. This hydroxyl group can serve as an introduction site for a structural unit derived from a monomer having a functional group including a carbon-carbon unsaturated double bond and an isocyanate group. For example, by reacting a polymer having a hydroxyl group (prepolymer) with a monomer having a functional group including a carbon-carbon unsaturated double bond and an isocyanate group, a base polymer having a carbon-carbon unsaturated double bond is obtained.

For the purpose of modifying cohesive force, heat resistance, crosslinkability, and the like, other monomer components copolymerizable with the above (meth)acrylic acid alkyl ester may optionally be further used. Examples of such monomer components include carboxyl-group-containing monomers such as acrylic acid and methacrylic acid; acid anhydride monomers such as maleic anhydride and itaconic anhydride; sulfonic-acid-group-containing monomers such as styrenesulfonic acid and allylsulfonic acid; (N-substituted) amide monomers such as (meth)acrylamide, N,N-dimethyl(meth)acrylamide, and acryloyl morpholine; (meth)acrylic acid aminoalkyl monomers such as aminoethyl (meth)acrylate; (meth)acrylic acid alkoxyalkyl monomers such as methoxyethyl (meth)acrylate; maleimide monomers such as N-cyclohexylmaleimide and N-isopropylmaleimide; itaconimide monomers such as N-methylitaconimide and N-ethylitaconimide; succinimide monomers; vinyl monomers such as vinyl acetate, vinyl propionate, N-vinylpyrrolidone, and methylvinylpyrrolidone; cyanoacrylate monomers such as acrylonitrile and methacrylonitrile; epoxy-group-containing acrylic monomers such as glycidyl (meth)acrylate; glycol-based acrylic ester monomers such as polyethylene glycol (meth)acrylate and polypropylene glycol (meth)acrylate; acrylic ester monomers having a heterocyclic ring, a halogen atom, a silicon atom, or the like, such as tetrahydrofurfuryl (meth)acrylate, fluorinated (meth)acrylate, and silicone (meth)acrylate; olefin monomers such as isoprene, butadiene, and isobutylene; and vinyl ether monomers such as vinyl ether. These monomer components may be used alone, or two or more thereof may be used in combination.

The content of the other monomer components copolymerizable with the (meth)acrylic acid alkyl ester in the monomer composition may be any suitable amount. Specifically, the other monomer components copolymerizable with the (meth)acrylic acid alkyl ester are used such that the total of the (meth)acrylic acid alkyl ester, the hydroxyl-group-containing monomer, and the optional other monomer components copolymerizable with the (meth)acrylic acid alkyl ester is 100 mol%.

The polymer having a hydroxyl group can be obtained by any suitable method. For example, the (meth)acrylic polymer having a hydroxyl group can be obtained by polymerizing, by any suitable polymerization method, a monomer composition including a (meth)acrylic acid alkyl ester, a hydroxyl-group-containing monomer, and optional other monomer components copolymerizable with the (meth)acrylic acid alkyl ester.

As described above, the base polymer of the adhesive composition is, for example, a polymer obtained by reacting the above polymer having a hydroxyl group with a monomer composition including a monomer having a functional group including a carbon-carbon unsaturated double bond and an isocyanate group. By reacting the hydroxyl group of the polymer having a hydroxyl group with the isocyanate group of the monomer having a functional group including a carbon-carbon unsaturated double bond and an isocyanate group, a base polymer into which a carbon-carbon unsaturated double bond has been introduced is obtained. By using this base polymer, it is possible to provide an adhesive composition having favorable filling properties for irregularities and adhesiveness, while being capable of preventing adhesive residue from remaining on an adherend upon peeling.

Examples of the monomer having a functional group including a carbon-carbon unsaturated double bond and an isocyanate group include monomers having an acryloyl group or a methacryloyl group and also having an isocyanate group, such as 2-(2-methacryloyloxyethyloxy)ethyl isocyanate, 2-isocyanatoethyl acrylate (2-acryloyloxyethyl isocyanate), 2-isocyanatoethyl methacrylate (2-methacryloyloxyethyl isocyanate), methacryloyl isocyanate, 1,1-(bisacryloyloxymethyl)ethyl isocyanate, and m-isopropenyl-α,α-dimethylbenzyl isocyanate. These may be used alone, or two or more thereof may be used in combination.

The amount of the monomer having a carbon-carbon unsaturated double bond and an isocyanate group added relative to the number of moles of the hydroxyl groups of the polymer having a hydroxyl group is preferably 10 mol% to 90 mol%, more preferably 30 mol% to 85 mol%, and still more preferably 50 mol% to 80 mol%. When the amount of the monomer having a carbon-carbon unsaturated double bond and an isocyanate group added is within the above range, the adhesive composition can be satisfactorily cured by irradiation with active energy rays, and an adhesive composition having favorable peelability is provided. When the amount of the monomer having a carbon-carbon unsaturated double bond and an isocyanate group added exceeds 90 mol%, the number of reaction sites with a crosslinking agent may become too small, and a sufficient crosslinking effect may not be obtained.

Further, for example, monomers constituting a (meth)acrylic polymer can be broadly classified into hydrophilic monomers, hydrophobic monomers, and monomers other than hydrophilic monomers and hydrophobic monomers.

As the hydrophilic monomer, any suitable monomer having a polar group can be used. Specific examples include carboxyl-group-containing monomers such as acrylic acid, methacrylic acid, carboxyethyl acrylate, carboxypentyl acrylate, itaconic acid, maleic acid, fumaric acid, and crotonic acid; acid anhydride monomers such as maleic anhydride and itaconic anhydride; hydroxyl-group-containing monomers such as 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate, and (4-hydroxymethylcyclohexyl)methyl methacrylate; sulfonic-acid-group-containing monomers such as styrenesulfonic acid, allylsulfonic acid, 2-(meth)acrylamide-2-methylpropanesulfonic acid, (meth)acrylamidepropanesulfonic acid, sulfopropyl (meth)acrylate, and (meth)acryloyloxynaphthalenesulfonic acid; phosphate-group-containing monomers such as 2-hydroxyethyl acryloyl phosphate; (N-substituted) amide monomers such as (meth)acrylamide, N,N-dimethyl(meth)acrylamide, N-butyl(meth)acrylamide, N-methylol(meth)acrylamide, N-methylolpropane (meth)acrylamide, and acryloyl morpholine; (meth)acrylic acid aminoalkyl monomers such as aminoethyl (meth)acrylate, N,N-dimethylaminoethyl (meth)acrylate, and t-butylaminoethyl (meth)acrylate; (meth)acrylic acid alkoxyalkyl monomers such as methoxyethyl (meth)acrylate and ethoxyethyl (meth)acrylate; maleimide monomers such as N-cyclohexylmaleimide, N-isopropylmaleimide, N-laurylmaleimide, and N-phenylmaleimide; itaconimide monomers such as N-methylitaconimide, N-ethylitaconimide, N-butylitaconimide, N-octylitaconimide, N-2-ethylhexylitaconimide, N-cyclohexylitaconimide, and N-laurylitaconimide; succinimide monomers such as N-(meth)acryloyloxymethylene succinimide, N-(meth)acryloyl-6-oxyhexamethylene succinimide, and N-(meth)acryloyl-8-oxyoctamethylene succinimide; vinyl monomers such as vinyl acetate, vinyl propionate, N-vinylpyrrolidone, methylvinylpyrrolidone, vinylpyridine, vinylpiperidone, vinylpyrimidine, vinylpiperazine, vinylpyrazine, vinylpyrrole, vinylimidazole, vinyloxazole, vinylmorpholine, N-vinyl carboxamides, styrene, α-methylstyrene, and N-vinylcaprolactam; cyanoacrylate monomers such as acrylonitrile and methacrylonitrile; epoxy-group-containing acrylic monomers such as glycidyl (meth)acrylate; glycol-based acrylic ester monomers such as polyethylene glycol (meth)acrylate, polypropylene glycol (meth)acrylate, methoxyethylene glycol (meth)acrylate, and methoxypolypropylene glycol (meth)acrylate; acrylic ester monomers having a heterocyclic ring, a halogen atom, a silicon atom, or the like, such as tetrahydrofurfuryl (meth)acrylate, fluorinated (meth)acrylate, and silicon-containing (meth)acrylate; and polyfunctional monomers such as hexanediol di(meth)acrylate, (poly)ethylene glycol di(meth)acrylate, (poly)propylene glycol di(meth)acrylate, neopentyl glycol di(meth)acrylate, pentaerythritol di(meth)acrylate, trimethylolpropane tri(meth)acrylate, pentaerythritol tri(meth)acrylate, dipentaerythritol hexa(meth)acrylate, epoxy acrylate, polyester acrylate, and urethane acrylate. As the hydrophilic monomer, a hydroxyl-group-containing monomer and/or an (N-substituted) amide monomer can be suitably used. The hydrophilic monomer may be used alone, or two or more thereof may be used in combination.

As the hydrophobic monomer, any suitable monomer may be used as long as it is hydrophobic. Specific examples include vinyl alkyl ethers or aryl ethers having an alkyl group having 9 to 30 carbon atoms, such as vinyl 2-ethylhexanoate, vinyl laurate, vinyl stearate, and stearyl vinyl ether; alkyl esters of (meth)acrylic acid having 6 to 30 carbon atoms, such as hexyl (meth)acrylate, heptyl (meth)acrylate, octyl (meth)acrylate, isooctyl acrylate, isononyl acrylate, decyl (meth)acrylate, isodecyl (meth)acrylate, dodecyl (meth)acrylate, 2-ethylhexyl (meth)acrylate, benzyl (meth)acrylate, lauryl (meth)acrylate, oleyl (meth)acrylate, palmityl (meth)acrylate, and stearyl (meth)acrylate; unsaturated vinyl esters of (meth)acrylic acid derived from fatty acids and aliphatic alcohols; monomers derived from cholesterol; and olefin monomers such as 1-butene, 2-butene, 1-pentene, 1-hexene, 1-octene, isobutylene, and isoprene. The hydrophobic monomer may be used alone, or two or more thereof may be used in combination. In the present invention, the hydrophobic monomer means a monomer having a solubility of 0.02 g or less in 100 g of water.

The base polymer may further include monomer components other than the hydrophilic monomer and the hydrophobic monomer. Examples of such other monomer components include alkyl acrylates such as butyl acrylate and ethyl acrylate. The other monomer component may be used alone, or two or more thereof may be used in combination.

When a polymer having a hydroxyl group is used, the proportion of hydrophilic monomers other than the hydroxyl-group-containing monomer relative to 100 mol% of the total amount of monomer components other than the hydroxyl-group-containing monomer is preferably 5 to 50 mol%, more preferably 15 to 45 mol%, and still more preferably 25 to 40 mol%. When the proportion of hydrophilic monomers other than the hydroxyl-group-containing monomer relative to 100 mol% of the total amount of monomer components other than the hydroxyl-group-containing monomer is 5 mol% or more, crosslinking points and double-bond introduction points can be provided to an extent sufficient to exhibit their functions. Further, when the proportion of hydrophilic monomers other than the hydroxyl-group-containing monomer relative to 100 mol% of the total amount of monomer components other than the hydroxyl-group-containing monomer is 50 mol% or less, the polarity of the adhesive is not excessively increased, so that water resistance and moisture resistance can be maintained, and the adhesive force can also be maintained because the cohesive force does not become excessively high.

Although the foregoing description has mainly been directed to a case in which the base polymer is obtained by reacting a monomer composition for a base polymer (base-polymer monomer composition 1) including a polymer having a hydroxyl group and a monomer having a carbon-carbon unsaturated double bond and an isocyanate group, the base polymer is not limited thereto.

That is, the base polymer can be produced, for example, by a method in which a polymer having a reactive functional group (a first functional group) and a compound having a functional group capable of reacting with the first functional group to form a bond (a second functional group) and a functional group including a carbon-carbon unsaturated double bond are reacted and bonded while maintaining the radiation polymerizability of the carbon-carbon unsaturated double bond. Accordingly, the base polymer preferably includes a structural portion derived from the polymer having the first functional group and a structural portion derived from the compound having the second functional group and the carbon-carbon unsaturated double bond.

Examples of the functional group including a carbon-carbon unsaturated bond include, in addition to an acryloyl group and a methacryloyl group, a vinyl group, a propenyl group, and an isopropenyl group.

Examples of the combination of the first functional group and the second functional group include a carboxy group and an epoxy group, an epoxy group and a carboxy group, a carboxy group and an aziridyl group, an aziridyl group and a carboxy group, a hydroxy group and an isocyanate group, and an isocyanate group and a hydroxy group. Among these, in view of ease of reaction tracking, a combination of a hydroxy group and an isocyanate group and a combination of an isocyanate group and a hydroxy group are preferred. The above combination may be used alone, or two or more thereof may be used.

The base polymer can be produced, for example, by a method in which, after raw material monomers including a monomer component having the first functional group are polymerized (copolymerized) to obtain a polymer having the first functional group, a compound having the second functional group and a carbon-carbon unsaturated double bond is caused to undergo a condensation reaction or an addition reaction with the polymer while maintaining the radiation polymerizability of the carbon-carbon unsaturated double bond.

In polymerization of the monomer components, various common solvents may be used. Examples of the solvent include organic solvents such as esters including ethyl acetate and n-butyl acetate; aromatic hydrocarbons including toluene and benzene; aliphatic hydrocarbons including n-hexane and n-heptane; alicyclic hydrocarbons including cyclohexane and methylcyclohexane; and ketones including methyl ethyl ketone and methyl isobutyl ketone. The solvent may be used alone, or two or more thereof may be used.

A polymerization initiator, chain transfer agent, emulsifier, and the like used for radical polymerization of the monomer components are not particularly limited, and may be selected and used. The weight-average molecular weight of the polymer can be controlled by the amounts of the polymerization initiator and the chain transfer agent used and by the reaction conditions, and the amounts thereof used are appropriately adjusted according to the types thereof.

As the polymerization initiator used for polymerization of the monomer components, a thermal polymerization initiator, a photopolymerization initiator (photoinitiator), or the like can be used depending on the type of polymerization reaction. The polymerization initiator may be used alone, or two or more thereof may be used in combination.

The thermal polymerization initiator is not particularly limited, and examples thereof include an azo polymerization initiator, a peroxide polymerization initiator, and a redox polymerization initiator. The amount of the thermal polymerization initiator used is preferably 1 part by mass or less, more preferably 0.005 to 1 part by mass, and still more preferably 0.02 to 0.5 part by mass, relative to 100 parts by mass of the total monomer components constituting the polymer having the first functional group.

As the photopolymerization initiator used for polymerization of the monomer components, those exemplified below as photopolymerization initiators contained in the adhesive composition may be used.

The reaction between the polymer having the first functional group and the compound having the second functional group and a radiation-polymerizable functional group can be carried out, for example, by stirring in a solvent in the presence of a catalyst. Examples of the solvent include those described above. The catalyst is appropriately selected according to the combination of the first functional group and the second functional group. In the reaction, the reaction temperature is, for example, 5 to 100°C, and the reaction time is, for example, 1 to 36 hours.

In addition to the base polymer, the adhesive composition of this embodiment contains a photopolymerization initiator.

As the photopolymerization initiator that may be contained in the adhesive composition, any suitable initiator may be used. Examples of the photopolymerization initiator include acylphosphine oxide photoinitiators such as ethyl 2,4,6-trimethylbenzyl phenylphosphinate and (2,4,6-trimethylbenzoyl)-phenylphosphine oxide; α-ketol compounds such as 4-(2-hydroxyethoxy)phenyl(2-hydroxy-2-propyl) ketone, α-hydroxy-α,α'-dimethylacetophenone, 2-methyl-2-hydroxypropiophenone, and 1-hydroxycyclohexyl phenyl ketone; acetophenone compounds such as methoxyacetophenone, 2,2-dimethoxy-2-phenylacetophenone, 2,2-diethoxyacetophenone, and 2-methyl-1-[4-(methylthio)-phenyl]-2-morpholinopropan-1-one; benzoin ether compounds such as benzoin ethyl ether, benzoin isopropyl ether, and anisoin methyl ether; ketal compounds such as benzyl dimethyl ketal; aromatic sulfonyl chloride compounds such as 2-naphthalenesulfonyl chloride; photoactive oxime compounds such as 1-phenone-1,1-propanedione-2-(o-ethoxycarbonyl)oxime; benzophenone compounds such as benzophenone, benzoyl benzoic acid, and 3,3'-dimethyl-4-methoxybenzophenone; thioxanthone compounds such as thioxanthone, 2-chlorothioxanthone, 2-methylthioxanthone, 2,4-dimethylthioxanthone, isopropylthioxanthone, 2,4-dichlorothioxanthone, 2,4-diethylthioxanthone, and 2,4-diisopropylthioxanthone; camphorquinone; halogenated ketones; acylphosphonates; and α-hydroxyacetophenones such as 2-hydroxy-1-(4-(4-(2-hydroxy-2-methylpropionyl)benzyl)phenyl)-2-methylpropan-1-one. Preferred examples include 2,2-dimethoxy-2-phenylacetophenone and 2-hydroxy-1-(4-(4-(2-hydroxy-2-methylpropionyl)benzyl)phenyl)-2-methylpropan-1-one. The photopolymerization initiator may be used alone, or two or more thereof may be used in combination.

As the photopolymerization initiator, commercially available products may also be used. Examples include products under the trade names Omnirad 127D and Omnirad 651, manufactured by IGM Resins.

The photopolymerization initiator may be used in any suitable amount. The content of the photopolymerization initiator is preferably 0.5 to 20 parts by mass, and more preferably 0.5 to 10 parts by mass, relative to 100 parts by mass of the base polymer. If the content of the photopolymerization initiator is less than 0.5 part by mass, sufficient curing may not be achieved upon irradiation with active energy rays. If the content of the photopolymerization initiator exceeds 20 parts by mass, storage stability of the adhesive composition may decrease.

The adhesive composition may further include any suitable additive. Examples of the additive include a crosslinking agent, a catalyst (for example, a platinum catalyst), a tackifier, a plasticizer, a pigment, a dye, a filler, an antioxidant, a conductive material, an ultraviolet absorber, a light stabilizer, a release modifier, a softening agent, a surfactant, a flame retardant, and a solvent.

The adhesive composition preferably further includes a crosslinking agent. Examples of the crosslinking agent include an isocyanate-based crosslinking agent, an epoxy-based crosslinking agent, an aziridine-based crosslinking agent, and a chelate-based crosslinking agent. The content of the crosslinking agent may be adjusted to any suitable amount, but is preferably 0.5 to 20 parts by mass, more preferably 4 to 15 parts by mass, and still more preferably 6 to 12 parts by mass, relative to 100 parts by mass of the base polymer. The flexibility of the adhesive layer formed by the adhesive composition can be controlled by the content of the crosslinking agent. When the content of the crosslinking agent is 0.5 part by mass or more, an appropriate cohesive force can be obtained, which is preferable. When the content of the crosslinking agent is 20 parts by mass or less, an appropriate adhesive force can be obtained, which is preferable.

As the crosslinking agent, an isocyanate-based crosslinking agent is preferably used. An isocyanate-based crosslinking agent is preferred because it can react with various functional groups. Particularly preferably, a crosslinking agent having three or more isocyanate groups is used. By using an isocyanate-based crosslinking agent as the crosslinking agent and setting the content of the crosslinking agent within the above range, it is possible to form an adhesive layer having favorable peelability and markedly reduced adhesive residue even after heating.

Next, a case will be described in which an adhesive containing a base polymer and a radiation-polymerizable monomer or oligomer having a functional group such as a radiation-polymerizable carbon-carbon double bond is used.

When an adhesive to which a radiation-polymerizable monomer or oligomer is added is used, any suitable monomer or oligomer may be used as the radiation-polymerizable monomer and oligomer. Examples of the radiation-polymerizable monomer include urethane (meth)acrylate, trimethylolpropane tri(meth)acrylate, tetramethylolmethane tetra(meth)acrylate, pentaerythritol tri(meth)acrylate, pentaerythritol tetra(meth)acrylate, dipentaerythritol monohydroxypenta(meth)acrylate, dipentaerythritol hexa(meth)acrylate, and 1,4-butanediol di(meth)acrylate. Examples of the radiation-polymerizable oligomer include urethane oligomers, polyether oligomers, polyester oligomers, polycarbonate oligomers, and polybutadiene oligomers. As the oligomer, one having a molecular weight of preferably about 100 to 30000 is used. The monomer and the oligomer may be used alone, or two or more thereof may be used in combination.

The monomer and/or the oligomer may be used in any suitable amount according to the type of adhesive used. For example, the amount used is preferably 5 to 500 parts by mass, and more preferably 40 to 150 parts by mass, relative to 100 parts by mass of the base polymer constituting the adhesive.

As the base polymer contained in the adhesive to which a radiation-polymerizable monomer or oligomer is added, a suitable resin such as the above-described acrylic polymer is used according to the type of adhesive.

Further, the adhesive to which a radiation-polymerizable monomer or oligomer is added may appropriately contain a polymerization initiator, a crosslinking agent, and the like, and these are the same as the respective components described for the adhesive containing, as a base polymer, a polymer having a radiation-polymerizable functional group.

The adhesive layer may also contain a thermoplastic resin. Examples of the thermoplastic resin include natural or synthetic rubbers such as natural rubber, polyisobutylene, polyisoprene, chloroprene rubber, butyl rubber, and nitrile butyl rubber; olefin elastomers such as an ethylene-propylene copolymer, an ethylene-propylene-diene copolymer, an ethylene-vinyl acetate copolymer, polybutene, and chlorinated polyethylene; styrene elastomers such as a styrene-butadiene-styrene copolymer, a styrene-isoprene-styrene copolymer, and hydrogenated products thereof; polyester elastomers; polyamide elastomers; and various thermoplastic elastomers such as polyurethane elastomers. These rubber components or thermoplastic elastomer components may be used alone or in a combination of two or more.

The adhesive layer can be produced, for example, by applying (coating) an adhesive composition for forming the adhesive layer onto a release liner and drying the resulting adhesive composition layer, or by applying (coating) the adhesive composition onto a release liner. If necessary, heating and drying may be further performed.

The thickness of the adhesive layer is not particularly limited, but in view of exhibiting good adhesiveness to the two-dimensional material, it is preferably 2 µm or more, more preferably 5 µm or more, and still more preferably 10 µm or more, and in view of formability of a smooth adhesive layer, it is preferably 500 µm or less, more preferably 100 µm or less, and still more preferably 50 µm or less.

Further, in a case in which, in the separation step described above, a laminate including an adhesive tape as the support layer and the two-dimensional material is separated from the first substrate, the tensile elastic modulus of the adhesive layer in the adhesive tape in the laminate is preferably 1 MPa to 1000 MPa. In view of suppressing damage to the two-dimensional material due to deformation, the tensile elastic modulus of the adhesive layer is preferably 1 MPa or more, more preferably 5 MPa or more, more preferably 9 MPa or more, more preferably 10 MPa or more, more preferably 20 MPa or more, and still more preferably 100 MPa or more. Further, the tensile elastic modulus of the adhesive layer is preferably 1000 MPa or less, more preferably 200 MPa or less, and still more preferably 150 MPa or less. When the tensile elastic modulus of the adhesive layer near the first substrate during bubble formation is 1000 MPa or less, it becomes easier to suppress or prevent bubbles contributing to separation from escaping from an edge of the laminate before the bubbles become sufficiently large when bubbles are formed between the first substrate and the two-dimensional material.

The tensile elastic modulus of the adhesive layer is a tensile elastic modulus at 23°C.

Specifically, the tensile elastic modulus of the adhesive layer can be calculated as follows.

A cylindrical sample is prepared by rolling the adhesive layer so as to have a length of 30 mm and a diameter of 1 mm. Upper and lower 10-mm portions of the cylindrical sample in the length direction are gripped, and the cylindrical sample is pulled at a speed of 50 mm/min. Using a tensile tester, the initial tensile elastic modulus is calculated from the slope at a point at which the slope of stress with respect to strain is maximum between 10% strain and 100% strain. The calculated value is defined as the tensile elastic modulus of the adhesive layer.

Further, the tensile elastic modulus of the adhesive layer in the adhesive tape in the laminate separated from the first substrate can be regarded as being substantially the same as the tensile elastic modulus of the adhesive layer in the adhesive tape in the laminate during bubble formation.

Further, when the adhesive layer is a curable adhesive layer, it is preferable that the tensile elastic modulus of the adhesive layer after curing be within the above-described range.

Specifically, the tensile elastic modulus of the adhesive layer after curing can be calculated as follows.

A cylindrical sample is prepared by irradiating the adhesive layer with ultraviolet light at an integrated light amount of 450 mJ/cm² and rolling the adhesive layer so as to have a length of 30 mm and a diameter of 1 mm. Using a tensile tester, upper and lower 10-mm portions of the cylindrical sample in the length direction are gripped, and the cylindrical sample is pulled at a speed of 50 mm/min. The initial tensile elastic modulus calculated from the slope at a point at which the slope of stress with respect to strain is maximum between 10% strain and 100% strain is defined as the tensile elastic modulus of the adhesive layer after curing. When the adhesive after ultraviolet irradiation is brittle and easily broken and therefore cannot be rolled into a length of 30 mm and a diameter of 1 mm, the adhesive layer can be rolled without breakage by masking 5% or less, in the winding direction, of a portion at which winding is started, so that the masked portion is not irradiated with ultraviolet light.

Examples of the base material forming the adhesive tape include those made of a resin, a nonwoven fabric, a woven fabric, a metal foil, paper, and the like. Among these, in view of smoothness, handleability, cost, and the like, a base material made of a resin (resin base material) is preferred.

Specific examples of the resin forming the base material include polyester resins such as polyethylene terephthalate (PET), polyethylene naphthalate (PEN), polybutylene terephthalate (PBT), and polybutylene naphthalate (PBN); polyolefin resins such as an ethylene-vinyl acetate copolymer (EVA), an ethylene-methyl methacrylate copolymer, polyethylene, polypropylene, and an ethylene-propylene copolymer; polyurethane resins; polyvinyl alcohol; polyvinylidene chloride; polyvinyl chloride; a vinyl chloride-vinyl acetate copolymer; polyvinyl acetate; polyamide; polyimide; cellulose; fluororesins; polyether; polystyrene-based resins such as polystyrene; polycarbonate; and polyether sulfone. Among these, in view of tensile elastic modulus with flexibility, an ethylene-vinyl acetate copolymer (EVA), a polyolefin resin, and a polyurethane resin are preferred, and an ethylene-vinyl acetate copolymer (EVA) is particularly preferred.

The thickness of the base material may be set to any suitable value. The thickness of the base material is preferably 10 µm to 300 µm, and more preferably 50 µm to 150 µm.

As the base material, an unstretched film may be used, or a film subjected to uniaxial or biaxial stretching treatment may be used as necessary.

Further, when the adhesive layer 12 is an active-energy-ray-curable adhesive layer, the base material 11 preferably has a property of transmitting active energy rays such as ultraviolet light.

The tensile elastic modulus of the base material is preferably 10 MPa to 4000 MPa. In view of handleability of the adhesive tape, the tensile elastic modulus of the base material is preferably 10 MPa or more, more preferably 30 MPa or more, and still more preferably 50 MPa or more. Further, the tensile elastic modulus of the base material is preferably 4000 MPa or less, more preferably 1000 MPa or less, and still more preferably 100 MPa or less. By setting the tensile elastic modulus of the relatively hard base material among the members forming the adhesive tape to 4000 MPa or less, the tensile elastic modulus of the adhesive tape as the support layer can be more readily adjusted to 3000 MPa or less. As a result, when bubbles are formed between the first substrate and the two-dimensional material, it is easier to suppress or prevent bubbles contributing to separation from escaping from an edge of the laminate including the adhesive tape and the two-dimensional material before the bubbles become sufficiently large.

The tensile elastic modulus of the base material is a tensile elastic modulus at 23°C.

Specifically, the tensile elastic modulus of the base material can be calculated as follows. A sample of the base material having a width of 10 mm and a length of 20 mm is prepared. Using a tensile tester, upper and lower 5-mm portions of the sample in the length direction are gripped so that the distance between the grips is 10 mm, and the sample is pulled at a speed of 50 mm/min. The initial tensile elastic modulus calculated from the slope at a point at which the slope of stress with respect to strain is maximum between 10% strain and 100% strain is defined as the tensile elastic modulus of the base material. In the case of anisotropy in which the tensile elastic modulus varies depending on the tensile direction, an average of tensile elastic moduli obtained by pulling in at least two in-plane directions orthogonal to each other is used. For example, an average value of values respectively measured using two in-plane orthogonal directions (the MD direction and the TD direction) as a long-side direction (length direction) is used.

### Method for Manufacturing the Adhesive Tape

The adhesive tape can be manufactured by any suitable method. In the embodiment, the adhesive tape can be produced by forming an adhesive layer on a base material. The adhesive layer may be formed by applying, to the base material, the composition for forming the adhesive layer to form the adhesive layer, or the adhesive layer may be formed on any suitable release liner and then transferred to the base material. As the coating method, various methods may be employed, such as bar coating, air-knife coating, gravure coating, reverse gravure coating, reverse-roll coating, lip coating, slot-die coating, dip coating, offset printing, flexographic printing, and screen printing.

As described above, the present specification describes the following matters.
(1) A method for manufacturing a laminate, including:
   a step of forming bubbles between a first substrate and a two-dimensional material in a state in which a support layer is attached to the two-dimensional material on the first substrate; and
   a step of separating a laminate including the support layer and the two-dimensional material from the first substrate by forming the bubbles, or by pulling at least one of the support layer and the first substrate after forming the bubbles, wherein
   the support layer has re-peelability, and
   the laminate has a tensile elastic modulus at 23°C of 10 to 3000 MPa under the measurement conditions set forth below.
      Measurement conditions for the tensile elastic modulus of the laminate
   The tensile elastic modulus of the laminate is an initial tensile elastic modulus calculated from a slope at a point at which a slope of stress with respect to strain is maximum between 10% strain and 100% strain when a sample of the laminate having a width of 10 mm and a length of 20 mm is gripped at upper and lower 5-mm portions in the length direction and pulled at a speed of 50 mm/min.
(2) The method for manufacturing a laminate according to (1), wherein an adhesive force, measured at 23°C, of the support layer with respect to a silicon wafer is 0.001 N/20 mm to 2.0 N/20 mm when measured by 180° peeling at a tensile speed of 300 mm/min.
(3) The method for manufacturing a laminate according to (1) or (2), wherein the support layer is an adhesive tape including an adhesive layer and a base material.
(4) The method for manufacturing a laminate according to (3), wherein the base material has a tensile elastic modulus at 23°C of 10 to 4000 MPa under the measurement conditions set forth below.
   Measurement conditions for the tensile elastic modulus of the base material
   The tensile elastic modulus of the base material is an initial tensile elastic modulus calculated from a slope at a point at which a slope of stress with respect to strain is maximum between 10% strain and 100% strain when a sample of the base material having a width of 10 mm and a length of 20 mm is gripped at upper and lower 5-mm portions in the length direction and pulled at a speed of 50 mm/min.
(5) The method for manufacturing a laminate according to (3) or (4), wherein the adhesive layer has a tensile elastic modulus at 23°C of 1 to 1000 MPa under the measurement conditions set forth below.
   Measurement conditions for the tensile elastic modulus of the adhesive layer
   The tensile elastic modulus of the adhesive layer is an initial tensile elastic modulus calculated from a slope at a point at which a slope of stress with respect to strain is maximum between 10% strain and 100% strain when a cylindrical sample obtained by rolling the adhesive layer to a length of 30 mm and a diameter of 1 mm is gripped at upper and lower 10-mm portions in the length direction and pulled at a speed of 50 mm/min.
(6) The method for manufacturing a laminate according to any one of (3) to (5), wherein the adhesive layer is an adhesive layer that is cured upon supply of specified energy or a specified substance.
(7) The method for manufacturing a laminate according to (6), wherein the adhesive layer after curing has a tensile elastic modulus at 23°C of 1 to 1000 MPa under the measurement conditions set forth below.
   Measurement conditions for the tensile elastic modulus of the adhesive layer after curing
   The tensile elastic modulus of the adhesive layer is an initial tensile elastic modulus calculated from a slope at a point at which a slope of stress with respect to strain is maximum between 10% strain and 100% strain when a cylindrical sample obtained by irradiating the adhesive layer with ultraviolet light at an integrated light amount of 450 mJ/cm² and rolling the adhesive layer to a length of 30 mm and a diameter of 1 mm is gripped at upper and lower 10-mm portions in the length direction and pulled at a speed of 50 mm/min.
(8) The method for manufacturing a laminate according to (6) or (7), including, before the step of forming the bubbles, a step of supplying specified energy or a specified substance to cure the adhesive layer.
(9) A method for manufacturing a two-dimensional material laminate, including:
   a step of placing, on a second substrate, the laminate obtained by the method for manufacturing a laminate according to any one of (1) to (8) such that a surface of the two-dimensional material of the laminate is in contact with the second substrate; and
   a step of transferring the two-dimensional material onto the second substrate by peeling the support layer, thereby obtaining a two-dimensional material laminate including the second substrate and the two-dimensional material.
(10) A two-dimensional material laminated on a second substrate and having an area of 100 mm² or more.
(11) The two-dimensional material according to (10), wherein a transfer rate is 70% or more.
(12) The two-dimensional material according to (10) or (11), wherein a contamination amount is -30% or more and 10% or less.
(13) The two-dimensional material according to any one of (10) to (12), wherein the two-dimensional material includes graphene, and has a mobility of 2000 cm²/V/s or more.

### Examples

The present invention will be described in detail below by way of Examples. However, the present invention is not limited to these Examples.

### <Adhesive Sheet 1>

A monomer composition (solid content concentration: 40%) was prepared by mixing three monomers, namely, 71.2 g of 2-ethylhexyl acrylate (2EHA) (60 mol% of the total amount of monomers not including a hydroxyl group), 36.4 g of acryloyl morpholine (ACMO) (40 mol% of the total amount of monomers not including a hydroxyl group), and 20.4 g of 4-hydroxybutyl acrylate (4HBA) (an amount corresponding to 22 mol% when the total amount of monomers not including a hydroxyl group is taken as 100 mol%), together with 0.3 mass% of a polymerization initiator (Nyper^{®} BW manufactured by NOF Corporation) relative to the total mass of the monomers, and a solvent (ethyl acetate). The monomer composition was charged into a 1 L separable round-bottom flask in a polymerization apparatus equipped with a separable cover, a dropping funnel, a thermometer, a nitrogen inlet tube, a Liebig condenser, a vacuum seal, a stirring rod, and a stirring blade, and the atmosphere was purged with nitrogen at room temperature for 2 hours while stirring. Thereafter, while nitrogen was being introduced and stirring was continued, polymerization was performed by holding at 61°C for 8 hours to obtain a resin solution. To the obtained resin solution, 12.0 g of a compound for introducing a carbon-carbon unsaturated double bond (Karenz MOI manufactured by Showa Denko K.K.) was added, the amount corresponding to 12 mol% when the total amount of monomers not including a hydroxyl group is taken as 100 mol%. Further, dibutyltin dilaurate IV (manufactured by Wako Pure Chemical Industries, Ltd.) was added in an amount of 0.063 part by mass relative to 100 parts by mass of resin solids, and a solvent (ethyl acetate) was added as appropriate so that the solid content concentration was adjusted to 15%. Thereafter, stirring was carried out in an air atmosphere at 50°C for 24 hours to obtain an adhesive solution A (adhesive composition) containing acrylic polymer A.

Next, 12 parts by mass of a polyisocyanate compound (Takenate D-101E manufactured by Mitsui Chemicals, Inc.) and 4 parts by mass of a photopolymerization initiator (Omnirad 651 manufactured by IGM Resins) were added to the adhesive solution A relative to 100 parts by mass of the acrylic polymer A, thereby preparing an adhesive solution A'.

The adhesive solution A' prepared above was applied onto a silicone-treated surface of a PET release liner, and was thermally crosslinked at 120°C for 2 minutes to form an adhesive layer having a thickness of 15 µm. Next, an ethylene-vinyl acetate copolymer (EVA) film having a thickness of 115 µm was bonded to the surface of the adhesive layer. Thereafter, after storage at 50°C for 24 hours, the obtained sheet was referred to as Adhesive Sheet 1.

### <Adhesive Sheet 2>

Adhesive Sheet 2 was produced in the same manner as Adhesive Sheet 1, except that, in Adhesive Sheet 1, 2EHA was changed to 90 mol% of the total amount of monomers not including a hydroxyl group, ACMO was changed to 10 mol% of the total amount of monomers not including a hydroxyl group, and Karenz MOI was changed to an amount corresponding to 18 mol% when the total amount of monomers not including a hydroxyl group was taken as 100 mol%, thereby obtaining Adhesive Sheet 2.

### <Adhesive Sheet 3>

Adhesive Sheet 3 was produced in the same manner as Adhesive Sheet 1, except that, in Adhesive Sheet 1, the EVA film was changed to a polyethylene terephthalate (PET) film having a thickness of 50 µm.

### <Adhesive Sheet 4>

A monomer composition (solid content concentration: 40%) was prepared by mixing three monomers, namely, 60.0 g of 2-ethylhexyl acrylate (2EHA), 65.4 g of methyl acrylate (MA), and 6.3 g of acrylic acid (AA), together with 0.3 mass% of a polymerization initiator (Nyper^{®} BW manufactured by NOF Corporation) relative to the total mass of the monomers, and a solvent (ethyl acetate). The monomer composition was charged into a 1 L separable round-bottom flask in a polymerization apparatus equipped with a separable cover, a dropping funnel, a thermometer, a nitrogen inlet tube, a Liebig condenser, a vacuum seal, a stirring rod, and a stirring blade, and the atmosphere was purged with nitrogen at room temperature for 2 hours while stirring. Thereafter, while nitrogen was being introduced and stirring was continued, the monomer composition was held at 61°C. for 8 hours for polymerization, thereby obtaining an adhesive solution B (adhesive composition) containing acrylic polymer B.

Next, 100 parts by mass of dipentaerythritol hexaacrylate (DPHA manufactured by Nippon Kayaku Co., Ltd.), 3 parts by mass of a polyisocyanate compound (Takenate D-101E manufactured by Mitsui Chemicals, Inc.), and 3 parts by mass of a photopolymerization initiator (Omnirad 651 manufactured by IGM Resins) were added to the adhesive solution B relative to 100 parts by mass of the acrylic polymer B, thereby preparing an adhesive solution B'.

The adhesive solution B' prepared above was applied onto a silicone-treated surface of a PET release liner, and was thermally crosslinked at 120°C for 2 minutes to form an adhesive layer having a thickness of 5 µm. Next, a PET film having a thickness of 188 µm was bonded to the surface of the adhesive layer. Thereafter, after storage at 50°C for 24 hours, the obtained sheet was referred to as Adhesive Sheet 4.

### <Adhesive Sheet 5>

Adhesive Sheet 5 was produced in the same manner as Adhesive Sheet 4, except that, in Adhesive Sheet 4, the PET film having a thickness of 188 µm was changed to an ethylene-vinyl acetate copolymer (EVA) film having a thickness of 115 µm.

### <Adhesive Sheet 6>

Adhesive Sheet 6 was produced in the same manner as Adhesive Sheet 1, except that, in Adhesive Sheet 1, 2EHA was changed to 75 mol% of the total amount of monomers not including a hydroxyl group, ACMO was changed to 25 mol% of the total amount of monomers not including a hydroxyl group, Takenate D-101E was changed to 4 parts by mass, and Omnirad 651 was changed to 3 parts by mass.

### <Formation of Epitaxial Metal Film on Single-Crystal Substrate Surface by Sputtering>

As the single-crystal substrate, the c-plane (0001) of sapphire (α-Al₂O₃) purchased from Adamant Namiki Precision Jewel Co., Ltd. was used.

The above single-crystal substrate was mounted in a chamber of an RF magnetron sputtering apparatus (CFS-4ES, Shibaura Mechatronics), and Cu metal was sputtered over the entire surface of the single-crystal substrate (Ar atmosphere, standard vacuum level: 0.6 Pa). Thus, a Cu film having a thickness of 1000 nm was epitaxially deposited to obtain a Cu/sapphire substrate.

### <CVD Formation of Graphene>

The above Cu/sapphire substrate was placed, as a substrate for graphene film formation, inside a quartz tube set in a ceramic tubular furnace manufactured by Asahi Rika Seisakusho (inner diameter: 26 mm when the substrate size was 200 mm², and inner diameter: 140 mm when the substrate size was 7854 mm² (4-inch wafer)). As the Cu/sapphire substrate, one having a substrate size of 10 mm × 20 mm or 7854 mm² (4-inch wafer) was used. Thereafter, under atmospheric pressure, the temperature was raised to a specified temperature (1000 to 1075°C) while argon and hydrogen were being supplied. After the specified temperature was reached, the substrate was held under the same conditions for 0 to 3 hours to reduce and smooth the Cu surface. Thereafter, methane was added at 10 to 200 ppm, and a chemical vapor deposition reaction was carried out for 90 minutes. After the reaction, the substrate was cooled, and after reaching room temperature (23°C), the Cu/sapphire substrate on which monolayer graphene had been formed (first laminate: laminate 1-1) was taken out from the quartz tube. By this reaction, a continuous monolayer graphene film covering the entire Cu surface was formed on the Cu surface. In addition, 90% or more of the area of the formed graphene was monolayer graphene.

### <CVD Formation of h-BN>

An Fe-Ni alloy foil having a thickness of 20 µm (manufactured by Nilaco Corporation, main components: Fe (about 64%) and Ni (32%)) was placed, as a substrate for h-BN film formation, inside an alumina tube (inner diameter: 24 mm) set in a ceramic tubular furnace manufactured by Asahi Rika Seisakusho. As the Fe-Ni alloy foil, one having a substrate size of 20 mm × 20 mm was used. Thereafter, the inside of the tube was set to a reduced-pressure hydrogen atmosphere (10 to 100 Pa), and the temperature was raised to a specified temperature (1000 to 1100°C). After the specified temperature was reached, the substrate was held under the same conditions for 0 to 3 hours to reduce and smooth the alloy foil surface. Subsequently, the temperature of the tubular furnace was raised to 1100 to 1200°C, and vaporized borazine (B₃N₃H₆) gas was introduced at a partial pressure of 0.1 to 1 Pa. The sample was slowly cooled to 700°C (cooling rate: 5°C/min) to promote uniform deposition of h-BN, and was then rapidly cooled to room temperature (23°C). By this reaction, a continuous h-BN film covering the entire surface of the Fe-Ni alloy foil was formed on the surface of the Fe-Ni alloy foil. In this manner, an Fe-Ni alloy foil on which multilayer h-BN had been formed (first laminate: laminate 1-2) was obtained.

### <Example 1>

Adhesive Sheet 1 was attached to the surface of the graphene of the first laminate (laminate 1-1) having an area of 200 mm² using a roller (pressing force: 2 kg/10 mm), followed by autoclave treatment at 50°C and 5 atm for 30 minutes, and then allowed to stand at room temperature and atmospheric pressure for 30 minutes, thereby obtaining a second laminate. A portion of the adhesive sheet in the substrate peripheral region of the second laminate was trimmed with a cutter knife to form an exposed Cu/graphene surface portion of about 5 mm².

UV treatment was performed from the base-material side of Adhesive Sheet 1 with an irradiation dose of 450 mJ/cm² using a UV irradiation apparatus (UM-810, manufactured by Nitto Seiki Co., Ltd.).

The exposed Cu/graphene surface portion of the second laminate (substrate/graphene/Adhesive Sheet 1) was clipped with an electrode clip to serve as a working electrode, and the laminate was immersed in an acrylic water tank filled with a 1 M aqueous sodium hydroxide solution, together with a Pt electrode as a counter electrode and an Ag/AgCl electrode as a reference electrode, and a DC voltage of 4 V was applied using a potentiostat (Vertex10A, manufactured by IVIUM). After voltage application, the laminate of graphene/Adhesive Sheet 1 (third laminate) was separated from the Cu/sapphire substrate by generation of gas (bubbles) due to electrolysis at the interface between the Cu surface and the graphene.

The laminate of graphene/Adhesive Sheet 1 (third laminate) was immersed in deionized water and washed, and was attached by water-assisted lamination to a silicon substrate with an oxide film (manufactured by SUMCO Corporation, silicon (crystal plane (100)), size: 200 mm² (20 mm × 10 mm), surface thermal oxidation-oxide film thickness: 300 nm; hereinafter also simply referred to as "silicon substrate") using a roller (pressing force: 2 kg/10 mm), allowed to stand at room temperature for 24 hours, and then heat-treated at 90°C for 3 hours to obtain a fourth laminate. The graphene was attached to the oxide film (SiO₂) of the silicon substrate.

The silicon substrate in the fourth laminate was fixed, and Adhesive Sheet 1 was peeled at a peel angle of 180 degrees and a peel rate of 300 mm/min using a tensile tester (VPA-H200F, manufactured by Kyowa Interface Science Co., Ltd.), thereby transferring the graphene onto the silicon substrate and obtaining a laminate of the silicon substrate and the graphene in Example 1 (fifth laminate). The fifth laminate is also referred to as a two-dimensional material laminate.

### <Example 2>

A laminate of the silicon substrate and graphene in Example 2 (fifth laminate) was obtained in the same manner as in Example 1, except that no UV irradiation was performed.

### <Example 3>

A laminate of the silicon substrate and graphene in Example 3 (fifth laminate) was obtained in the same manner as in Example 1, except that UV irradiation was not performed before separation of the third laminate from the Cu substrate, but was performed immediately before peeling Adhesive Sheet 1 from the silicon substrate.

### <Example 4>

A laminate of the silicon substrate and graphene in Example 4 (fifth laminate) was obtained in the same manner as in Example 1, except that Adhesive Sheet 2 was used as the adhesive sheet instead of Adhesive Sheet 1.

### <Example 5>

A laminate of the silicon substrate and graphene in Example 5 (fifth laminate) was obtained in the same manner as in Example 1, except that Adhesive Sheet 3 was used as the adhesive sheet instead of Adhesive Sheet 1.

### <Example 6>

A laminate of the silicon substrate and graphene in Example 6 (fifth laminate) was obtained in the same manner as in Example 1, except that the area of the first laminate was changed to 7854 mm² (4-inch wafer), and the size of the silicon substrate onto which transfer was made was changed to 12100 mm² (110 mm × 110 mm).

### <Example 7>

A laminate of the silicon substrate and graphene in Example 7 (fifth laminate) was obtained in the same manner as in Example 1, except that Adhesive Sheet 5 was used as the adhesive sheet instead of Adhesive Sheet 1.

### <Example 8>

Adhesive Sheet 6 was attached to the surface of the h-BN of the first laminate (laminate 1-2) having an area of 200 mm² using a roller (pressing force: 2 kg/10 mm), followed by autoclave treatment at 50°C and 5 atm for 30 minutes, and then allowed to stand at room temperature and atmospheric pressure for 30 minutes, thereby obtaining a second laminate. A portion of the adhesive sheet in the substrate peripheral region of the second laminate was trimmed with a cutter knife to form an exposed Fe-Ni/h-BN surface portion of about 5 mm².

UV treatment was performed from the base-material side of Adhesive Sheet 6 with an irradiation dose of 450 mJ/cm² using a UV irradiation apparatus (UM-810, manufactured by Nitto Seiki Co., Ltd.).

The exposed Fe-Ni/h-BN surface portion of the second laminate (substrate/graphene/Adhesive Sheet 6) was clipped with an electrode clip to serve as a working electrode, and the laminate was immersed in an acrylic water tank filled with a 1 M aqueous sodium hydroxide solution, together with a Pt electrode as a counter electrode and an Ag/AgCl electrode as a reference electrode, and a DC voltage of 4 V was applied using a potentiostat (Vertex10A, manufactured by IVIUM). After voltage application, the laminate of h-BN/Adhesive Sheet 6 (third laminate) was separated from the Fe-Ni alloy foil by generation of gas (bubbles) due to electrolysis at the interface between the Fe-Ni surface and the h-BN.

The laminate of h-BN/Adhesive Sheet 6 (third laminate) was immersed in deionized water and washed, and was attached by water-assisted lamination to a silicon substrate with an oxide film using a roller (pressing force: 2 kg/10 mm), allowed to stand at room temperature for 24 hours, and then heat-treated at 90°C for 3 hours to obtain a fourth laminate. The h-BN was attached to the oxide film (SiO₂) of the silicon substrate.

The silicon substrate in the fourth laminate was fixed, and Adhesive Sheet 6 was peeled at a peel angle of 180 degrees and a peel rate of 300 mm/min using a tensile tester (VPA-H200F, manufactured by Kyowa Interface Science Co., Ltd.), thereby transferring the h-BN onto the silicon substrate and obtaining a laminate of the silicon substrate and the h-BN in Example 8 (fifth laminate). The fifth laminate is also referred to as a two-dimensional material laminate.

### <Comparative Example 1>

A Cu/sapphire substrate on which monolayer graphene had been formed (first laminate: laminate 1-1) was prepared in the same manner as in Example 1. Subsequently, instead of Adhesive Sheet 1, a toluene solution of polymethyl methacrylate (PMMA) was coated on the surface of the graphene on the Cu using a spin coater, and a portion of the PMMA in the substrate peripheral region was trimmed by solvent cleaning in the same manner as in Example 1 to form a portion of about 5 mm² in which the Cu/graphene surface was exposed.

An electrode clip was attached to the exposed Cu/graphene surface portion of the laminate (substrate/graphene/PMMA), and the graphene/PMMA laminate was separated from the Cu substrate by voltage application in the same manner as in Example 1.

The graphene/PMMA laminate floating on the surface of the 1 M aqueous sodium hydroxide solution was scooped up together with the solution using a watch glass and transferred to a Petri dish containing separately prepared deionized water. The graphene/PMMA laminate was washed by repeating scooping with the watch glass and transfer into the deionized water ten times. The graphene/PMMA laminate floating on the deionized water after the repeated washing was scooped up with the same silicon substrate with an oxide film as used in Example 1, allowed to stand at room temperature for 24 hours, and then heat-treated at 90°C for 3 hours to obtain a laminate (silicon substrate/graphene/PMMA). The PMMA could not be peeled off like an adhesive sheet, and a laminate of the silicon substrate and graphene could not be obtained.

### <Comparative Example 2>

A laminate of the silicon substrate and graphene in Comparative Example 2 (fifth laminate) was obtained in the same manner as in Example 1, except that Adhesive Sheet 4 was used as the adhesive sheet instead of Adhesive Sheet 1.

### <Comparative Example 3>

A laminate of the silicon substrate and graphene in Comparative Example 3 (fifth laminate) was obtained in the same manner as in Example 1, except that no UV irradiation was performed and, when the laminate of graphene/Adhesive Sheet 1 (third laminate) was separated from the Cu surface, Adhesive Sheet 1 was peeled in air at a peel angle of 180 degrees and a peel rate of 300 mm/min using a tensile tester (VPA-H200F, manufactured by Kyowa Interface Science Co., Ltd.).

### <Comparative Example 4>

A laminate of the silicon substrate and graphene in Comparative Example 4 (fifth laminate) was obtained in the same manner as in Example 3, except that, when the laminate of graphene/Adhesive Sheet 1 (third laminate) was separated from the Cu surface, Adhesive Sheet 1 was peeled in air at a peel angle of 180 degrees and a peel rate of 300 mm/min.

### <Tensile Elastic Modulus>

Using a sample of the adhesive-sheet/graphene laminate (third laminate) obtained at an intermediate stage of Examples 1 to 8 and Comparative Examples 2 to 4, the sample having a width of 10 mm and a length of 20 mm (in Example 6, a sample cut from the central portion of the 4-inch wafer to a width of 10 mm and a length of 20 mm), upper and lower 5 mm portions in the length direction were gripped so that the distance between the grips was 10 mm, and the sample was pulled at a speed of 50 mm/min. Using a tensile tester (AUTOGRAPH AGS-X, manufactured by Shimadzu Corporation), the initial tensile elastic modulus was determined from the slope at a point at which the slope of stress with respect to strain was maximum between 10% strain and 100% strain, and the determined initial tensile elastic modulus was defined as the tensile elastic modulus of the laminate (third laminate). Since the PMMA/graphene laminate of Comparative Example 1 was a thin layer and difficult to handle, the tensile elastic modulus thereof was separately determined by preparing a 50 µm-thick cast film of PMMA and measuring the cast film in the same manner as described above.

The tensile elastic modulus of the base material was determined by measuring a base material alone prepared during production of Adhesive Sheets 1 to 6 in the same manner as described above.

The tensile elastic modulus of the adhesive layer was determined, for each of the case with UV irradiation and the case without UV irradiation, by using a cylindrical sample obtained by rolling the adhesive layer, obtained before lamination with the base material during production of Adhesive Sheets 1 to 6, to a length of 30 mm and a diameter of 1 mm, gripping upper and lower 10 mm portions in the length direction, and measuring in the same manner as described above. UV treatment was performed from the base-material side of the adhesive sheet with an irradiation dose of 450 mJ/cm² using a UV irradiation apparatus (UM-810, manufactured by Nitto Seiki Co., Ltd.). The UV treatment was performed before the adhesive layer was rolled into the cylindrical sample.

Each tensile elastic modulus was a value measured at 23°C.

### <Re-Peelability of the Support Layer>

Each of the adhesive sheets used in Examples 1 to 8 and Comparative Examples 2 to 4 was cut to a width of 20 mm and a length of 10 cm, and the release liner was peeled off and removed.

Subsequently, each adhesive sheet of the respective example was pressure-bonded and attached to a silicon wafer (4-inch silicon mirror wafer) by one reciprocation with a 2 kg roller, and then allowed to stand for 30 minutes.

Except for Example 2 and Comparative Example 3, UV irradiation was performed from the base-material side of the adhesive sheet at an irradiation dose of 450 mJ/cm² using a UV irradiation apparatus (UM-810, manufactured by Nitto Seiki Co., Ltd.).

Using a tensile tester (VPA-H200F, manufactured by Kyowa Interface Science Co., Ltd.), the peel force measured when the adhesive sheet was peeled at a peel angle of 180 degrees and a peel rate of 300 mm/min was measured as re-peelability A (180° peel force against a silicon wafer) (N/20 mm). The measurement temperature was 23°C.

Further, the peel force when the adhesive sheet was actually peeled from the silicon substrate in Examples 1 to 8 and Comparative Examples 2 to 4 was measured as re-peelability B (180° peel force upon release of the two-dimensional material from the silicon substrate) (N/10 mm). The measurement temperature was 23°C.

### <Transfer Rate>

For the laminate of the silicon substrate and graphene or the laminate of the silicon substrate and h-BN (fifth laminate) obtained in Examples 1 to 8 and Comparative Examples 2 to 4, an image of graphene or h-BN remaining on the surface of the transfer-receiving material (the oxide film (SiO₂) of the silicon substrate) was acquired as a digital image using an optical microscope (VHX-8000, manufactured by Keyence Corporation). The digital images were acquired, as observation images at 500× objective magnification, at 9 locations on surface of the graphene or the h-BN of the laminate having dimensions of 10 mm × 20 mm (7854 mm² (4-inch wafer size) in Example 6). Specifically, the center of the substrate was designated as point E, and 2 points located 6.5 mm to the left and right of point E (50 mm in Example 6) were designated as points D and F, respectively. Further, points located 2.5 mm above and below point D (50 mm in Example 6) were designated as points A and G, respectively. Similarly, points located 2.5 mm above and below point E (50 mm in Example 6) were designated as points B and H, respectively, and points located 2.5 mm above and below point F (50 mm in Example 6) were designated as points C and I, respectively. Using a 500 µm × 300 µm region from each digital image acquired for points A to I, RGB separation and binarization analysis of each component image were performed with the software "ImageJ," and the area ratio of graphene or h-BN in the relevant digital image was determined as a percentage. The average value of the area ratios of graphene or h-BN in the digital images at the nine points A to I was taken as the transfer rate (%).

### <Low Contamination (Contamination Amount)>

The laminates of the silicon substrate and graphene or h-BN obtained in Examples 1 to 8 and Comparative Examples 2 to 4 were subjected to ESCA analysis. The contamination amount was defined as an increase in the carbon content (atomic %) calculated by ESCA analysis relative to the carbon content (atomic %) obtained by the same measurement for the graphene laminate or the h-BN laminate on the Cu surface or the Fe-Ni alloy foil surface before transfer.

The carbon content was determined, for the surface of the target substrate, as the elemental ratio of carbon (atomic %) out of the total amount of the five elements carbon, oxygen, nitrogen, silicon, and copper, by performing narrow-scan analysis for those five elements by X-ray photoelectron spectroscopy (ESCA). As the analyzer, "Quantum 2000" manufactured by ULVAC PHI was used.

The analyzer and measurement conditions used for measuring the carbon content are shown below.
- Analyzer: Quantum 2000 manufactured by ULVAC PHI
- X-ray source: monochromatic AlKα
- X Ray setting: 200 µm in diameter [15 kV, 30 W]
- Binding energy correction: the peak derived from the C-C bond was corrected to 285.0 eV
- Charge neutralization conditions: combined use of a neutralizer gun and an Ar ion gun (neutralization mode)

Samples having a contamination amount of -30% or more and 10% or less were evaluated as having low contamination.

### <Mobility>

For each of the laminates of the silicon substrate and graphene (fifth laminate) obtained in Examples 1 to 7 and Comparative Examples 2 to 4, a resist (AZ5214-E, manufactured by Clariant) was formed on the graphene by spin casting (300 rpm for 5 seconds, followed by 3300 rpm for 30 seconds). From resist coating through pattern exposure and removal of the unexposed portions of the resist, the procedure was carried out under UV-shielded conditions. Subsequently, baking was performed on a 90°C hot plate for 1 minute to remove excess solvent.

The laminate on which the resist film had been formed was set in an exposure apparatus (PALET DDB-701, manufactured by Neoark Corporation), and exposure was carried out at 60 mW/cm² for 1.1 seconds so as to form a transistor channel pattern.

Subsequently, in order to carry out development, the exposed laminate was immersed for 100 seconds in NMD-3 (a 2.38% organic alkaline aqueous solution manufactured by Tokyo Ohka Kogyo Co., Ltd.) while being gently agitated, and was then immersed in water to wash off the NMD-3, thereby removing the unexposed portions of the resist.

The fifth laminate, on the surface of which the transistor channel pattern remained, was subjected to an ashing treatment (PR-500, Yamato Scientific Co., Ltd.) to remove graphene in regions not covered with the pattern. Thereafter, the pattern was removed with acetone to obtain a graphene channel pattern.

With respect to the fifth laminate after completion of channel processing, a resist film was again formed by spin casting, and patterning was performed using an exposure apparatus such that portions other than portions where electrodes were to be provided at opposite ends of the graphene channel were covered with the resist, followed by development treatment.

On the fifth laminate that had been subjected to graphene channel processing and in which portions other than the portions where electrodes were to be provided were covered with the resist, Ni was deposited to a thickness of 10 angstroms on the surface of the resist of the laminate under a reduced pressure of 10⁻⁴ Pa using a vacuum deposition apparatus (KB-750, manufactured by Kenix), followed by deposition of Au to a thickness of 300 angstroms.

By removing the resist with acetone, Ni/Au electrodes including a source electrode S and a drain electrode D were formed at respective ends of the graphene channel, thereby producing a field-effect transistor using graphene as a channel material.

The laminate from which the field-effect transistor had been fabricated was placed in a chamber equipped with measurement probes (MJ-8, manufactured by Apollo Wave), and was treated at 200°C for 15 hours under a reduced pressure of 10⁻⁴ Pa or less, thereby cleaning the surface of the graphene channel. The laminate was returned to room temperature while maintained under reduced pressure, and the measurement probes were brought into contact with the source electrode S and the drain electrode D. Using a semiconductor parameter analyzer (B1500A, manufactured by Keysight), a variable voltage (Vg) of -40 to 40 V was applied to the silicon (Si) substrate serving as the gate electrode G, and the current (Id) flowing when 20 mV was applied between S and D was measured, thereby calculating the electron mobility of the graphene.

The results for Examples 1 to 8 and Comparative Examples 1 to 4 are collectively shown in Table 1 below together with the respective measurement results.

In Table 1, "Tensile Elastic Modulus of Laminate" means the tensile elastic modulus of the graphene/adhesive-sheet laminate or the h-BN/adhesive-sheet laminate (third laminate). In Comparative Example 1, however, the tensile elastic modulus of PMMA is shown. Further in Table 1, the symbol "-" indicates that the measurement was not performed or could not be performed.

| | | **Example 1** | **Example 2** | **Example 3** | **Example 4** | **Example 5** | **Example 6** | **Example 7** | **Example 8** | **Comparative Example 1** | **Comparative Example 2** | **Comparative Example 3** | **Comparative Example 4** |
|---|---|---|---|---|---|---|---|---|---|---|---|---|---|
| **Configuration** / **Physical Properties** / **Characteristics** | **Support layer** | Adhesive Sheet 1 | Adhesive Sheet 1 | Adhesive Sheet 1 | Adhesive Sheet 2 | Adhesive Sheet 3 | Adhesive Sheet 1 | Adhesive Sheet 5 | Adhesive Sheet 6 | PMMA | Adhesive Sheet 4 | Adhesive Sheet 1 | Adhesive Sheet 1 |
| | **Two-dimensional material** | Graphene | Graphene | Graphene | Graphene | Graphene | Graphene | Graphene | h-BN | Graphene | Graphene | Graphene | Graphene |
| | **Area of two-dimensional material (mm²)** | 200 | 200 | 200 | 200 | 200 | 7054 | 200 | 200 | 200 | 200 | 200 | 200 |
| | **Tensile elastic modulus of laminate (MPa)** | 72 | 44 | 72 | 52 | 2551 | 72 | 71 | 48 | 2700 | 3902 | 44 | 72 |
| | **Tensile elastic modulus of base material (MPa)** | 55 | 55 | 55 | 55 | 4000 | 55 | 55 | 55 | - | 4000 | 55 | 55 |
| | **Tensile elastic modulus of adhesive layer before curing (MPa)** | 4 | 4 | 4 | 18 | 4 | 4 | 06 | 07 | - | 0.6 | 4 | 4 |
| | **Tensile elastic modulus of adhesive layer after curing (MPa)** | 136.3 | - | 136.3 | 29.6 | 136.3 | 136.3 | 220 | 125 | - | 220 | - | 136.3 |
| | **Manufacturing method** | UV -> bubbles | Bubbles (no UV) | Bubbles -> UV | UV -> bubbles | UV -> bubbles | UV -> bubbles | UV -> bubbles | UV -> bubbles | Bubbles (no UV) | UV ->bubbles | No UV / no bubbles | No bubbles -> UV |
| **Evaluation** | **Re-peelablllty A of support layer (N/20 mm)** | 0.07 | 0.52 | 007 | 0.06 | 0.07 | 0.07 | 0.17 | 0.11 | Difficult to peel | 0.15 | 0.52 | 0.07 |
| | **Re-peelability B of support layer (N/20 mm)** | 0.15 | 0.80 | 0.16 | 0.01 | 0.30 | 0.15 | 0.22 | 0.16 | | 0.20 | 0.80 | 0.15 |
| | **Transfer rate (%)** | 99 | 75 | 79 | 90 | 70 | 98 | 70 | 85 | - | 40 | 5 | 10 |
| | **Low contamination property (contamination amount) (%)** | -18 | -20 | -10 | 5 | -5 | 7 | -22 | 6 | - | -35 | 25 | 8 |
| | **Mobility (cm²/V/s)** | 4000 | 3000 | 3000 | 2000 | 2000 | 3700 | 2200 | - | - | 500 | 2000 | 2000 |

In Examples 1 to 8, an adhesive sheet was uset as a support layer having re- peelability, the manufacturing process included a bubble formation step, and the elastic modulus of the graphene/ashesive-sheet laminate or the h-BN/adhesive-sheet laminate (third laminate) was within a range of 10 to 3000 MPa. As a results the support layer was readily peeled from the graphene or h-BN, the graphene or h-BN was transferred at a high transfer rate, the transferred graphene or h-BN also exhibited favorable low contamination, and the transferred graphene exhibited high mobility.

Further, Example 1, in which UV irradiation was performed before the bubble formation step to cure the adhesive layer of the adhesive sheet, exhibited a higher graphene transfer rate and higher mobility than Example 2 and Example 3.

On the other hand, in Comparative Example 1, in which spin-coated PMMA was used as the support layer, the PMMA could not be peeled from the graphene. Although it is also possible to wash away and remove the PMMA using a solvent, if a solvent washing step is required, productivity is reduced, and damage to the graphene due to the solvent is also a concern. In a case in which the PMMA was washed and removed, a graphene transistor was fabricated using a sample obtained by twice repeating a process of immersing the sample in acetone at 50°C for 10 minutes, taking out the sample, immersing the sample in fresh acetone at 50°C for 30 minutes without drying, and then taking out the sample, followed by drying. The mobility was measured to be 1500 cm²/V/s.

Further, in Comparative Example 2, in which the elastic modulus of the graphene/adhesive-sheet laminate (third laminate) was as high as 3902 MPa, the graphene transfer rate was relatively low. The mobility of the transferred graphene was also relatively low, and the low-contamination properties were also relatively poor.

In Comparative Examples 3 and 4, in which the manufacturing process did not include a bubble formation step, the graphene transfer rate was relatively lower. Comparative Example 3 also exhibited relatively poor low-contamination properties.

Although the present invention has been described in detail with reference to a specific embodiment, those skilled in the art will appreciate that various changes and modifications can be made without departing from the spirit and scope of the present invention.

This application is based on Japanese Patent Application No. 2023-223306 filed on December 28, 2023, the entirety of which is incorporated herein by reference.

### REFERENCE SIGNS LIST

10) Support Layer
11) Base Material
12) Adhesive Layer
21) First Substrate
30) Two-Dimensional Material
40) Second Substrate
101) Laminate (First Laminate)
102) Laminate (Second Laminate)
103) Laminate (Third Laminate)
104) Laminate (Fourth Laminate)
105) Two-Dimensional Material Laminate (Fifth Laminate)

## Claims

1. A method for manufacturing a laminate, comprising:
a step of forming bubbles between a first substrate and a two-dimensional material in a state in which a support layer is attached to the two-dimensional material on the first substrate; and
a step of separating a laminate including the support layer and the two-dimensional material from the first substrate by forming the bubbles, or by pulling at least one of the support layer and the first substrate after forming the bubbles, wherein
the support layer has re-peelability, and
the laminate has a tensile elastic modulus at 23°C of 10 to 3000 MPa under the measurement conditions set forth below.
Measurement conditions for the tensile elastic modulus of the laminate
The tensile elastic modulus of the laminate is an initial tensile elastic modulus calculated from a slope at a point at which a slope of stress with respect to strain is maximum between 10% strain and 100% strain when a sample of the laminate having a width of 10 mm and a length of 20 mm is gripped at upper and lower 5-mm portions in the length direction and pulled at a speed of 50 mm/min.

2. The method for manufacturing a laminate according to claim 1, wherein an adhesive force, measured at 23°C, of the support layer with respect to a silicon wafer is 0.001 N/20 mm to 2.0 N/20 mm when measured by 180° peeling at a tensile speed of 300 mm/min.

3. The method for manufacturing a laminate according to claim 1, wherein the support layer is an adhesive tape including an adhesive layer and a base material.

4. The method for manufacturing a laminate according to claim 3, wherein the base material has a tensile elastic modulus at 23°C of 10 to 4000 MPa under the measurement conditions set forth below.
Measurement conditions for the tensile elastic modulus of the base material
The tensile elastic modulus of the base material is an initial tensile elastic modulus calculated from a slope at a point at which a slope of stress with respect to strain is maximum between 10% strain and 100% strain when a sample of the base material having a width of 10 mm and a length of 20 mm is gripped at upper and lower 5-mm portions in the length direction and pulled at a speed of 50 mm/min.

5. The method for manufacturing a laminate according to claim 3, wherein the adhesive layer has a tensile elastic modulus at 23°C of 1 to 1000 MPa under the measurement conditions set forth below.
Measurement conditions for the tensile elastic modulus of the adhesive layer
The tensile elastic modulus of the adhesive layer is an initial tensile elastic modulus calculated from a slope at a point at which a slope of stress with respect to strain is maximum between 10% strain and 100% strain when a cylindrical sample obtained by rolling the adhesive layer to a length of 30 mm and a diameter of 1 mm is gripped at upper and lower 10-mm portions in the length direction and pulled at a speed of 50 mm/min.

6. The method for manufacturing a laminate according to claim 3, wherein the adhesive layer is an adhesive layer that is cured upon supply of specified energy or a specified substance.

7. The method for manufacturing a laminate according to claim 6, wherein the adhesive layer after curing has a tensile elastic modulus at 23°C of 1 to 1000 MPa under the measurement conditions set forth below.
Measurement conditions for the tensile elastic modulus of the adhesive layer after curing
The tensile elastic modulus of the adhesive layer is an initial tensile elastic modulus calculated from a slope at a point at which a slope of stress with respect to strain is maximum between 10% strain and 100% strain when a cylindrical sample obtained by irradiating the adhesive layer with ultraviolet light at an integrated light amount of 450 mJ/cm² and rolling the adhesive layer to a length of 30 mm and a diameter of 1 mm is gripped at upper and lower 10-mm portions in the length direction and pulled at a speed of 50 mm/min.

8. The method for manufacturing a laminate according to claim 6, comprising, before the step of forming the bubbles, a step of supplying specified energy or a specified substance to cure the adhesive layer.

9. A method for manufacturing a two-dimensional material laminate, comprising:
a step of placing, on a second substrate, the laminate obtained by the method for manufacturing a laminate according to any one of claims 1 to 8 such that a surface of the two-dimensional material of the laminate is in contact with the second substrate; and
a step of transferring the two-dimensional material onto the second substrate by peeling the support layer, thereby obtaining a two-dimensional material laminate including the second substrate and the two-dimensional material.

10. A two-dimensional material laminated on a second substrate and having an area of 100 mm² or more.

11. The two-dimensional material according to claim 10, wherein a transfer rate is 70% or more.

12. The two-dimensional material according to claim 10 or 11, wherein a contamination amount is -30% or more and 10% or less.

13. The two-dimensional material according to claim 10 or 11, wherein the two-dimensional material includes graphene, and has a mobility of 2000 cm²/V/s or more.
